# EUROPEAN PATENT APPLICATION

(11) **EP 4 621 783 A1**
(43) Date of publication of application: **24.09.2025**
(21) Application number: 25151737.1
(22) Date of filing: 14.01.2025
(51) Int. Cl.: G11C 11/412, G11C 11/419, H10B 10/00

(54) **BALANCED STATIC RANDOM-ACCESS MEMORY (SRAM)**

(30) Priority: 22.03.2024 WO PCT/US2024/021233; 28.06.2024 US 202418759335
(71) Applicant: INTEL Corporation, Santa Clara, CA 95054 (US)
(72) Inventor: AUGUSTINE, Charles, Portland, OR 97229 (US); GHOSH, Amlan, Mebane, NC 27302 (US); MERCHANT, Feroze, Austin, TX 78750 (US); KHELLAH, Muhammad, Tigard, OR 97224 (US); MORROW, Patrick, Portland, OR 97229 (US); SUBRAMANIAM, Seenivasan, Hillsboro, OR 97124 (US)
(74) Representative: Viering, Jentschura & Partner mbB Patent- und Rechtsanwälte

(57) **Abstract**

Embodiments herein relate to a balanced eight-transistor (8T) static random-access memory (SRAM) cell having four n-type metal-oxide-semiconductor field-effect transistors (nMOSFETs) and four p-type MOSFETS. An nMOS write port and two pMOS read ports are optimized with a complementary field-effect transistor (CFET) process to achieve a high density. The cell is reconfigurable for various port configurations including 1R1W (1-read 1-write), 2R1W (2-read 1-write), 3R1W (3-read 1-write), 4R1W (4-read 1-write) and single/dual-ported SRAM with appropriate Vt (voltage threshold) targeting.

## Description

### PRIORITY CLAIM

This application is a continuation-in-part of PCT/US2024/021233, filed March 22, 2024, entitled "Static Random-Access Memory" and incorporated herein by reference.

### BACKGROUND

Computing devices often rely on memory devices including both volatile and non-volatile memory. The demand for memories has increased, e.g., as larger on-die caches are employed such as in high-performance processors. Static Random-Access Memory (SRAM) is a candidate for supporting these workloads and providing on-chip high density memory. However, various challenges are encountered in meeting performance and scalability goals.

### BRIEF DESCRIPTION OF THE DRAWINGS

The embodiments of the disclosure will be understood more fully from the detailed description given below and from the accompanying drawings of various embodiments of the disclosure, which, however, should not be taken to limit the disclosure to the specific embodiments, but are for explanation and understanding only.
FIG. 1 depicts plots of normalized density versus technology node for logic density (plot 100) and Static Random-Access Memory (SRAM) cell density (plot 101), in accordance with various embodiments.
FIG. 2 depicts a perspective view of a complementary field-effect transistor (CFET) device 200 in which an nMOS layer 220 is above a pMOS layer 215, in accordance with various embodiments.
FIG. 3 depicts a perspective view of a complementary field-effect transistor (CFET) device 300 in which a pMOS layer 320 is above an nMOS layer 315, in accordance with various embodiments.
FIG. 4 depicts an example circuit diagram of an eight-transistor (8T) SRAM memory cell 400 with a 2 read, 1 write configuration, where a write port includes pMOS transistors MP0 and MP1 and read ports use nMOS transistors MN0 and MN1, in accordance with various embodiments.
FIG. 5A depicts an example circuit diagram of an 8T SRAM memory cell 500 with a 2 read, 1 write configuration, where a write port includes nMOS transistors MN0 and MN1 and a read port includes pMOS transistors MP0 and MP1, in accordance with various embodiments.
FIG. 5B depicts an example circuit diagram of an 8T SRAM memory cell 510 with a 2 read, 1 write configuration, where a write port includes MN0 and MN1 and a read port includes MP0 and MP1, in accordance with various embodiments.
FIG. 5C depicts an example circuit diagram of an 8T SRAM memory cell 520 with a 2 read, 2 write configuration, where a write port includes MN0 and MN1 and read ports include MP0 and MP1, in accordance with various embodiments.
FIG. 5D depicts an example circuit diagram of an 8T SRAM memory cell 530 with a 3 read, 1 write configuration, where write ports includes MN0 and MN1 and read ports include MP0, MP1 and MN0, in accordance with various embodiments.
FIG. 5E depicts an example circuit diagram of an 8T SRAM memory cell 540 with a 4 read, 1 write configuration, where write ports includes MN0 and MN1 and read ports include MP0, MP1, MN0 and MN1, in accordance with various embodiments.
FIG. 6 depicts an example table of word line and bit line voltages for write, read and retention operations in the SRAM cells 400 and 500 of FIGs. 4 and 5A, respectively, in accordance with various embodiments.
FIG. 7A depicts an example plan view of a front side 700 of an 8T SRAM cell consistent with FIGs. 2 and 4, in accordance with various embodiments.
FIG. 7B depicts an example plan view of a back side 739 of the SRAM cell consistent with FIGs. 2 and 4 in accordance with various embodiments.
FIG. 7C depicts an example plan view of a first top metal layer M0 of the SRAM cell consistent with FIGs. 2 and 4, in accordance with various embodiments.
FIG. 7D depicts an example plan view of a first bottom metal layer BMO of the SRAM cell consistent with FIGs. 2 and 4, in accordance with various embodiments.
FIG. 7E depicts an example plan view of a second top metal layer M1 of the SRAM cell consistent with FIGs. 2 and 4, in accordance with various embodiments.
FIG. 8A depicts an example plan view of a front side 800 of an 8T SRAM cell consistent with FIGs. 2 and 5A, in accordance with various embodiments.
FIG. 8B depicts an example plan view of a back side 839 of the SRAM cell consistent with FIGs. 2 and 5 in accordance with various embodiments.
FIG. 8C depicts an example plan view of an M0 layer of the SRAM cell consistent with FIGs. 2 and 5A, in accordance with various embodiments.
FIG. 8D depicts an example plan view of a BMO layer of the SRAM cell consistent with FIGs. 2 and 5A, in accordance with various embodiments.
FIG. 8E depicts an example plan view of an M1 layer of the SRAM cell consistent with FIGs. 2 and 5A, in accordance with various embodiments.
FIG. 9A depicts an example plan view of a front side 900 of an 8T SRAM cell consistent with FIGs. 3 and 5A, in accordance with various embodiments.
FIG. 9B depicts an example plan view of a back side 939 of the SRAM cell consistent with FIGs. 3 and 5 in accordance with various embodiments.
FIG. 9C depicts an example plan view of an M0 layer of the SRAM cell consistent with FIGs. 3 and 5A, in accordance with various embodiments.
FIG. 9D depicts an example plan view of a BMO layer of the SRAM cell consistent with FIGs. 3 and 5A, in accordance with various embodiments.
FIG. 9E depicts an example plan view of an M1 layer of the SRAM cell consistent with FIGs. 3 and 5A, in accordance with various embodiments.
FIG. 10A depicts an example plan view of a front side 1000 of an 8T SRAM cell consistent with FIGs. 3 and 5B, in accordance with various embodiments.
FIG. 10B depicts an example plan view of a back side 1039 of the SRAM cell consistent with FIGs. 3 and 5B in accordance with various embodiments.
FIG. 10C depicts an example plan view of an M0 layer of the SRAM cell consistent with FIGs. 3 and 5B, in accordance with various embodiments.
FIG. 10D depicts an example plan view of a BMO layer of the SRAM cell consistent with FIGs. 3 and 5B, in accordance with various embodiments.
FIG. 10E depicts an example plan view of an M1 layer of the SRAM cell consistent with FIGs. 3 and 5B, in accordance with various embodiments.
FIG. 10F depicts an example plan view of a BM1 layer of the SRAM cell consistent with FIGs. 3 and 5B, in accordance with various embodiments.
FIG. 10G depicts an example table of word line and bit line voltages for write, read and retention operations in the SRAM cell of FIG. 5B, in accordance with various embodiments.
FIG. 11A depicts an example plan view of a front side 1100 of an 8T SRAM cell consistent with FIGs. 3 and 5C, in accordance with various embodiments.
FIG. 11B depicts an example plan view of a back side 1139 of the SRAM cell consistent with FIGs. 3 and 5C in accordance with various embodiments.
FIG. 11C depicts an example plan view of an M0 layer of the SRAM cell consistent with FIGs. 3 and 5C, in accordance with various embodiments.
FIG. 11D depicts an example plan view of a BMO layer of the SRAM cell consistent with FIGs. 3 and 5C, in accordance with various embodiments.
FIG. 11E depicts an example plan view of an M1 layer of the SRAM cell consistent with FIGs. 3 and 5C, in accordance with various embodiments.
FIG. 11F depicts an example table of word line and bit line voltages for write, read and retention operations in the SRAM cell of FIG. 5C, in accordance with various embodiments.
FIG. 12A depicts an example plan view of a front side 1200 of an 8T SRAM cell consistent with FIGs. 3 and 5D, in accordance with various embodiments.
FIG. 12B depicts an example plan view of a back side 1239 of the SRAM cell consistent with FIGs. 3 and 5D in accordance with various embodiments.
FIG. 12C depicts an example plan view of an M0 layer of the SRAM cell consistent with FIGs. 3 and 5D, in accordance with various embodiments.
FIG. 12D depicts an example plan view of a BMO layer of the SRAM cell consistent with FIGs. 3 and 5D, in accordance with various embodiments.
FIG. 12E depicts an example plan view of an M1 layer of the SRAM cell consistent with FIGs. 3 and 5D, in accordance with various embodiments.
FIG. 12F depicts an example plan view of a BM1 layer of the SRAM cell consistent with FIGs. 3 and 5D, in accordance with various embodiments.
FIG. 12G depicts an example table of word line and bit line voltages for write, read and retention operations in the SRAM cell of FIG. 5D, in accordance with various embodiments.
FIG. 13A depicts an example plan view of a front side 1300 of an 8T SRAM cell consistent with FIGs. 3 and 5E, in accordance with various embodiments.
FIG. 13B depicts an example plan view of a back side 1339 of the SRAM cell consistent with FIGs. 3 and 5E in accordance with various embodiments.
FIG. 13C depicts an example plan view of an M0 layer of the SRAM cell consistent with FIGs. 3 and 5E, in accordance with various embodiments.
FIG. 13D depicts an example plan view of a BMO layer of the SRAM cell consistent with FIGs. 3 and 5E, in accordance with various embodiments.
FIG. 13E depicts an example plan view of an M1 layer of the SRAM cell consistent with FIGs. 3 and 5E, in accordance with various embodiments.
FIG. 13F depicts an example plan view of a BM1 layer of the SRAM cell consistent with FIGs. 3 and 5E, in accordance with various embodiments.
FIG. 13G depicts an example table of word line and bit line voltages for write, read and retention operations in the SRAM cell of FIG. 5E, in accordance with various embodiments.
FIG. 14 depicts an example view of an n-type metal-oxide-semiconductor field-effect transistor (nMOSFET) 1450 and p-type MOSFET 1460, in accordance with various embodiments.
FIG. 15 depicts an example perspective view of different layers and vias in an SRAM cell which uses CFET technology, in accordance with various embodiments.
FIG. 16 illustrates an example of components that may be present in a computing system 1650 for implementing the techniques (e.g., operations, processes, methods, and methodologies) described herein.
FIG. 17 depicts a flowchart of an example process for operating an SRAM cell, in accordance with various embodiments.

### DETAILED DESCRIPTION

As mentioned at the outset, various challenges are encountered in designing a Static Random-Access Memory (SRAM) cell.

On-chip cache memories are integral part computing systems. Both memory capacity and memory bandwidth need to be scaled to meet the demand of existing and emerging workloads. However, while there is a clear path for logic scaling, there is difficulty in achieving capacity and bandwidth goals.

Complementary field-effect transistor (CFET) technology can potentially offer solutions to memory scaling problems since it provides vertical stacking of p-type metal-oxide-semiconductor field-effect transistors (pMOSFETs or pMOS) and n-type MOSFETs (nMOSFET or nMOS). By vertically stacking p-type and n-type MOSFETs, 2X density scaling can be achieved.

For example, CFET-optimized designs for SRAM can include eight transistors (8T) which allow for a dual-read or a single-write (2R1W) operation. For example, the read can be enabled through dual nMOS ports and the write can be enabled through a pMOS port. However, with a weaker pMOS and a stronger nMOS, the write operation may not be completed successfully. Trends indicate an nMOSFET is relatively stronger than a pMOSFET having the same device dimensions due to factors such as the lower mobility of holes in the pMOS compared to electrons in the nMOS.

The solutions provided herein address the above and other disadvantages. In one aspect, a balanced 8T memory cell is provided having four nMOSFETs and four pMOSFETS, where an nMOS write port and two pMOS read ports are optimized with the CFET process to achieve a high density. The proposed cell, e.g., bit cell, is reconfigurable for various port configurations including 1R1W (1-read 1-write), 2R1W (2-read 1-write), 3R1W (3-read 1-write), 4R1W (4-read 1-write) and single/dual-ported SRAM with appropriate Vt (voltage threshold) targeting.

The solutions provide a number of advantages, including avoiding increasing the pMOS size to enable a successful write operation, in process technologies where the nMOS is stronger than the pMOS, thereby avoiding an increase in the area of the bit cell.

In an example implementation, an efficient layout topology in the CFET process is provided for implementing the 8T [1-4]R1W designs with an nMOS write port instead of a pMOS write port. [1-4]R1W refers to 1, 2, 3 or 4 reads and one write. To keep the symmetry between the nMOS and pMOS transistors, e.g., having the same number of nMOS and pMOS transistors, the read port is enabled through the one or more pMOS(s) and nMOS(s).

The solutions provide a number of advantages. For example, the proposed balanced 8T [1-4]R1W bit cell with an nMOS write port and pMOS read port(s) enables a design with lower area compared to a domino bit cell.

Additionally, the use of identical bit cell topologies across different Register File (RF) types of [1-4]R1W can accelerate the bit cell yield learning, process tuning, qualification and certification of a product portfolio.

Further, write bit line power can be improved due to smaller diffusion capacitance from the nMOS write port compared to the domino bit cell.

Moreover, since the read port is enabled by the pMOS, read stability is improved. Also, a smaller bit line helps to meet the read performance goal.

These and other features will be further apparent in view of the following discussion.

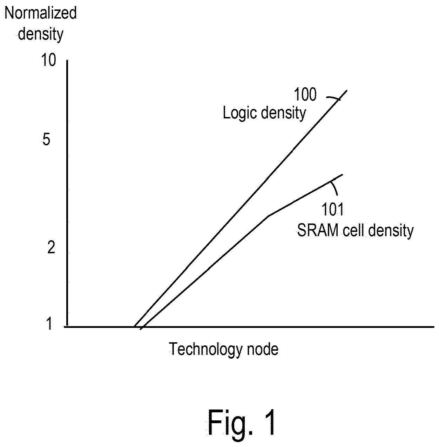

FIG. 1 depicts plots of normalized density versus technology node for logic density (plot 100) and Static Random-Access Memory (SRAM) cell density (plot 101), in accordance with various embodiments. Logic density continues to increase in proportion to the technology node, which represents an increasingly smaller dimension along the horizontal axis. However, SRAM cell density has increased at a lower rate, resulting in a disparity between logic and SRAM scaling across technology generations. The solutions provided herein address this issue by improving SRAM cell density.

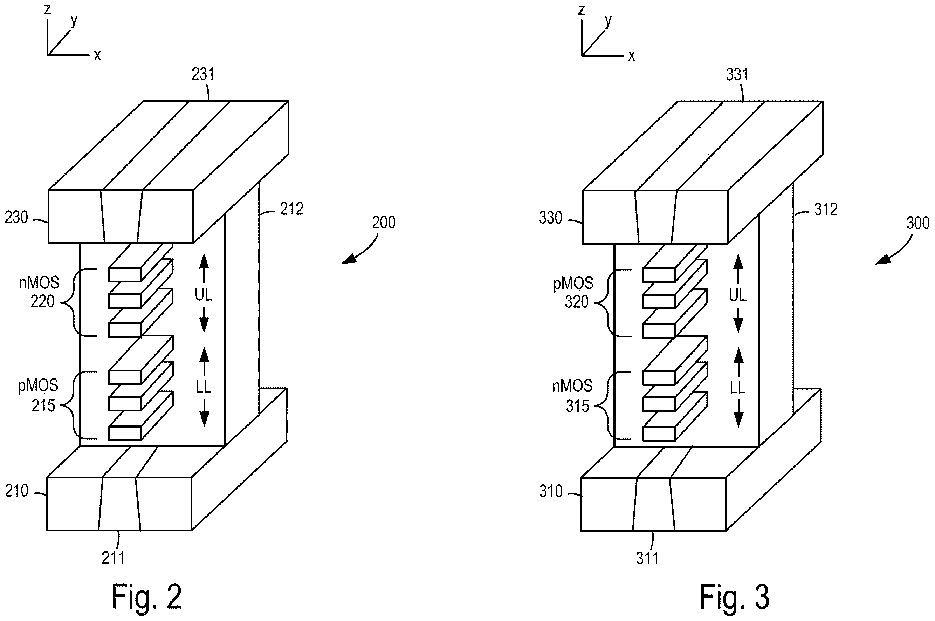

FIG. 2 depicts a perspective view of a complementary field-effect transistor (CFET) device 200 in which an nMOS layer 220 is above a pMOS layer 215, in accordance with various embodiments. CFET is a product of an evolution of transistor technology from Fin Field-Effect Transistor (FinFET) to nanosheet FET to CFET. CFET enables a 50% front end scaling with nMOS transistors stacked vertically on top of pMOS transistors, for example. CFET technology provides vertical integration of pMOS and nnMOS transistors.

The device 200 include a substrate region 210 with a metal line 211 (part of a bottom metal layer) at the bottom and a region 230 with a metal line 231 (part of a top metal layer) at the top. An elevated region 212 includes a lower layer (LL), e.g., a pMOSFET layer 215 (a p-type transistor layer) with one or more pMOS transistors, below an upper layer (UL), e.g., an nMOSFET layer 220 (an n-type transistor layer) with one or more nMOS transistors. A p-type transistor layer can include a p-type substrate, an n-well formed in the p-type substrate, and p+ diffusion regions in the n-well at the locations of the source/drain terminals of the pMOS transistors. An n-type transistor layer can include a p-type substrate and n+ diffusion regions in the p-type substrate at the locations of the source/drain terminals of the nMOS transistors.

The nMOS transistor layer may overlay, at least in part, and have an overlapping footprint with, the pMOS transistor layer. The substrate extends in an x-y plane. In this example, each transistor includes three channels in the form of ribbons, where each channel is surrounded by a gate, as a gate-all-around transistor. The transistors can also be referred to as RibbonFETs. Three channels is an example, as 2-5 channels can be used, for example.

pMOS source and drain regions/terminals can be connected to nMOS source and drain regions/terminals through vias since they are on different layers, e.g., the nMOS layer on the top and the pMOS layer on the bottom, in this example.

The device 200 represents part of a memory cell which includes multiple pMOS transistors at a first, e.g., lower layer of the memory cell and multiple nMOS transistors at a second, e.g., upper layer of the memory cell.

A Cartesian coordinate system with x, y and z axes is depicted in this and other figures for reference.

FIG. 3 depicts a perspective view of a complementary field-effect transistor (CFET) device 300 in which a pMOS layer 320 is above an nMOS layer 315, in accordance with various embodiments. The device 300 include a substrate region 310 with a metal line 311 at the bottom and a region 330 with a metal line 331 at the top. An elevated region 312 includes a lower layer (LL), e.g., an nMOSFET layer 315 (an n-type transistor layer) with one or more nMOS transistors, below an upper layer (UL), e.g., a pMOSFET layer 320 (a p-type transistor layer) with one or more pMOS transistors. The pMOS transistor layer may overlay, at least in part, and have an overlapping footprint with, the nMOS transistor layer.

pMOS source and drain regions can be connected to nMOS source and drain regions through vias since they are on different layers, e.g., the pMOS layer on the top and the nMOS layer on the bottom.

The device 300 represents part of a memory cell which includes multiple nMOS transistors at a first, e.g., lower layer of the memory cell and multiple pMOS transistors at a second, e.g., upper layer of the memory cell.

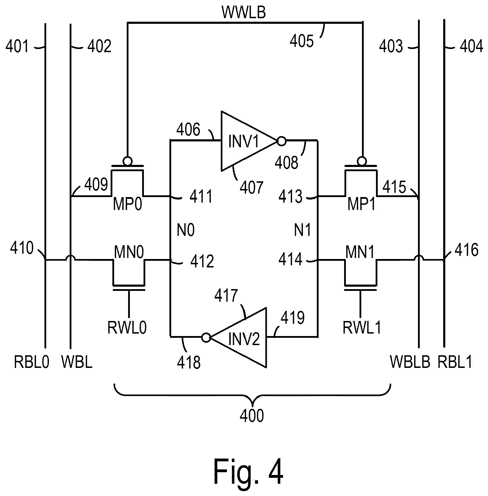

FIG. 4 depicts an example circuit diagram of an eight-transistor (8T) SRAM memory cell 400 with a 2 read, 1 write configuration, where a write port includes pMOS transistors MP0 and MP1 and read ports include nMOS transistors MN0 and MN1, in accordance with various embodiments. Read-port0 is enabled through MN0 and RBL0 and read-port1 is enabled through MN1 and RBL1. MP0, MP1, MN0 and MN1 are bit line access transistors because they allow access to bit lines which may be shared by multiple cells in a column of cells.

The cell includes first and second inverters INV1 407 and INV2 417, respectively, and first and second cross-coupled nodes NO and N1, respectively. First and second read bit lines 401 and 404 represent RBL0 and RBL1, respectively, and first and second write bit lines 402 and 403 represent WBL and WBLB, respectively. WBLB is a complementary bit line which carries a data bit which is the complement of the value on WBL. NO is coupled to WBL by a p-type transistor MP0 which has source/drain terminals 409 and 411, and to RBL0 by an n-type transistor MN0 which has source/drain terminals 410 and 412. N1 is coupled to WBLB by a p-type transistor MP1 which has source/drain terminals 413 and 415, and to RBL1 by an n-type transistor MN1 which has source/drain terminals 414 and 416. INV1 has an input node 406 and an output node 408. INV2 has an input node 419 and an output node 418. MP0 and MP1 receive a control gate voltage from a path 405 (control line) representing a complementary write word line WWLB, MN0 receives a control gate voltage RWL0 (a first read word line voltage), and MN1 receives a control gate voltage RWL1 (a second read word line voltage). WWLB carries a data bit which is the complement of the value on WWL.

Single-ended reads occur through a) RWL0 and RBL0 and b) RWL1 and RBL1, and a differential write occurs through WWLB and WBL/WBLB.

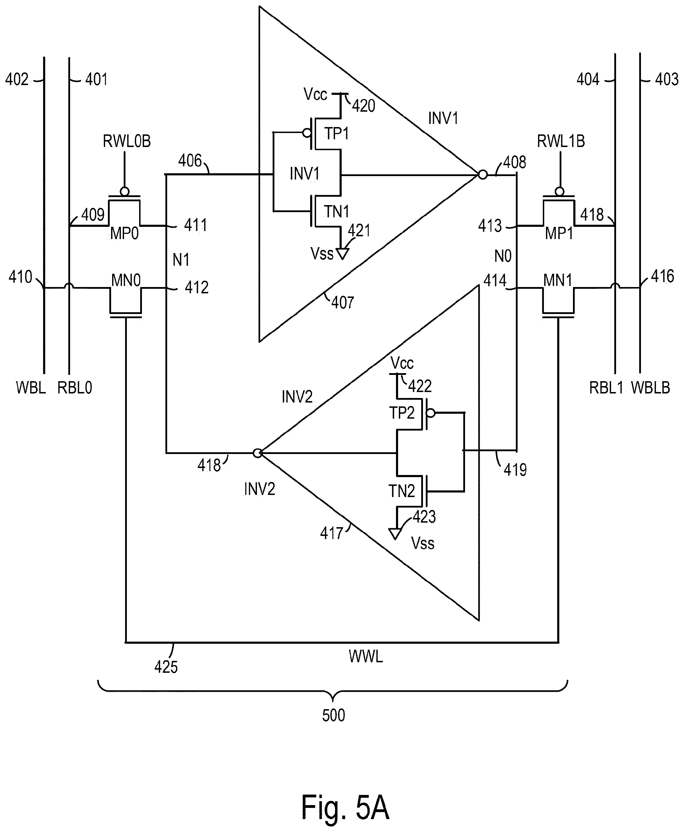

FIG. 5A depicts an example circuit diagram of an 8T SRAM memory cell 500 with a 2 read, 1 write configuration, where a write port includes nMOS transistors MN0 and MN1 and read ports include pMOS transistors MP0 and MP1, in accordance with various embodiments. Read-port0 is enabled through MP0 and RBL0 and read-port1 is enabled through MP1 and RBL1.

The circuit is similar to that of FIG. 4, except for the signals provided to the control gate of MP0, MP1, MN0 and MN1. Also, the positions of WBL and RBL0 are swapped and the positions of RBL1 and WBLB are swapped. Specifically, control gates of MN0 and MN1 are coupled to a path 425 (control line) representing a write word line WWL , a control gate of MP0 is coupled to RWL0B, and a control gate of MP1 is coupled to RWL1B. RWLOB is a first complementary read word line which carries a data bit which is the complement of the value on RWL0. RWL1B is a second complementary read word line which carries a data bit which is the complement of the value on RWL1.

Example details of the inverters are also depicted. INV1 includes, in series, a power supply node 420 at Vcc, a pMOS transistor TP1, an output node 408, an nMOS transistor TN1, and a ground node 421 at a voltage Vss such as 0 V. These transistors have their gates coupled to each other and to the input node 406 of INV1. A drain of TP1 and a drain of TN1 are coupled to each other and to the output node 408. A source of TP1 is coupled to the power supply node 420, and a source of TN1 is coupled to the ground node 421.

Single-ended reads occur through a) RWLOB and RBL0 and b) RWL1B and RBL1, and a differential write occurs through WWL and WBL/WBLB

INV2 includes, in series, a power supply node 422 at Vcc, a pMOS transistor TP2, an output node 418, an nMOS transistor TN2, and a ground node 423. These transistors have their gates coupled to each other and to the input node 419 of INV2. A drain of TP2 and a drain of TN2 are coupled to each other and to the output node 418. A source of TP2 is coupled to the power supply node 422, and a source of TN1 is coupled to the ground node 423.

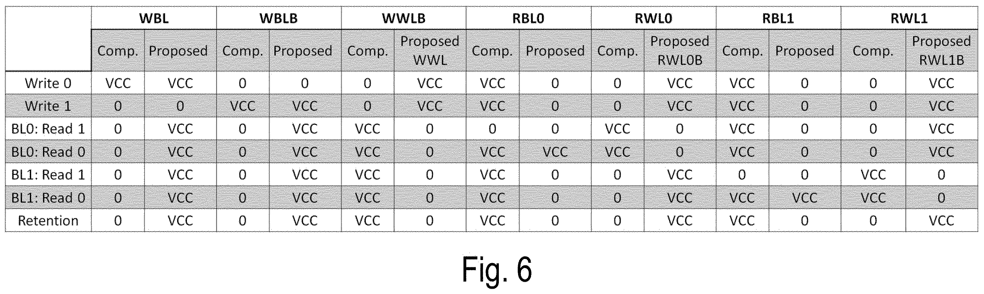

The table of FIG. 6 shows a comparison of read, write and retention operations in the SRAM cell implementations of FIGs. 4 and 5A. The SRAM cells both have a symmetric design with four nMOS and four pMOS transistors. Write is enabled through two pMOS transistors. On the other hand, a read port uses single-ended reading with RWL0 enabling reading through RBL0, and RWL1 enabling reading through RBL1. However, reading through the nMOS ports and writing through pMOS ports may not be an optimal strategy depending on the nMOS and pMOS device characteristics. For example, for the efficient pMOS based write operation, the internal node NO of the bit cell is flipped from "0" to "1" during a write operation, which requires a strong pMOS and a weak nMOS. However, in a process technology node with a stronger nMOS and a weaker pMOS, a write through the nMOS can be a better choice since the effective current during the write operation will be higher. Based on the past trend over several technology generations, nMOS is stronger than the pMOS and hence nMOS based write operation may be preferred.

A schematic of an 8T 2R1W bit cell with nMOS write is presented in FIG. 5A. To balance the number of transistors between nMOS and pMOS, the read operations are enabled through the pMOS ports. The table of FIG. 6 1 also shows the polarities of WBL, WBLB, WWL/WWLB, RBL0 and RWL0/RWL0B, RBL1 and RWL1/RWL1B. Since the write port is changed from pMOS to nMOS, WBL and WBLB are pre-charged to Vcc in FIG. 5A instead of 0 in FIG. 4. Similarly, the read port change from nMOS to pMOS results in RBL0 and RBL1 being pre-discharged to 0 in FIG. 5A instead of to Vcc in FIG. 4.

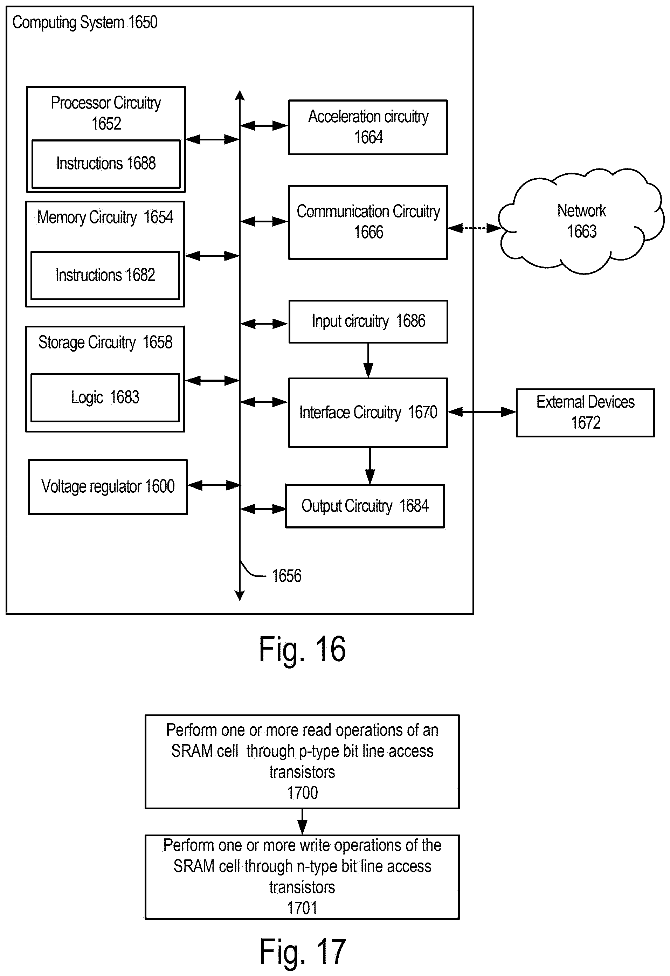

A control circuit such as a processor can be used to control the voltages/control signals on the various bit line and word lines to perform read and write operations as described herein. For example, the processor circuitry 1652 of FIG. 16 can be used. The processor circuitry can be configured to executed instructions stored on the memory circuitry 1654 to perform the read and write operations.

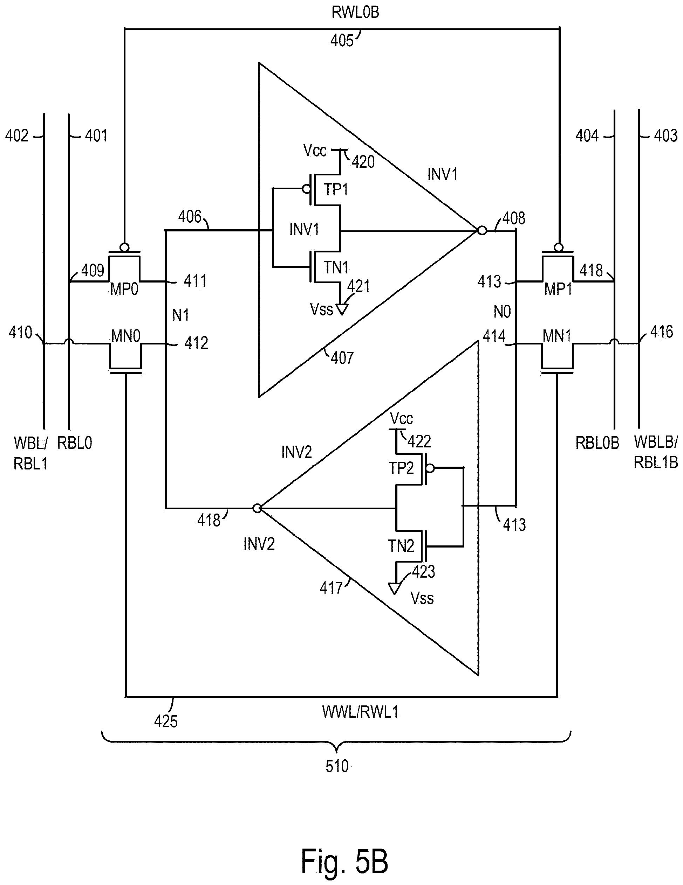

FIG. 5B depicts an example circuit diagram of an 8T SRAM memory cell 510 with a 2 read, 1 write configuration, where a write port includes MN0 and MN1 and a read port includes MP0 and MP1, in accordance with various embodiments. The bit line 402 is used for WBL or RBL1, the bit line 401 is used for RBL0, the bit line 404 is used for RBL0B, the bit line 403 is used for WBLB or RBL1B, the word line 425 is used for WWL or RWL1, and the word line/path 405 is used for RWLOB.

A first differential read occurs through a) RWLOB and RBL0/RBL0B. A second differential read occurs through b) RWL1 and RBL1/RBL1B. A differential write occurs through WWL and WBL/WBLB. The read operation b) and the write operation cannot occur in parallel. A control can decide which operation to invoke at a given time.

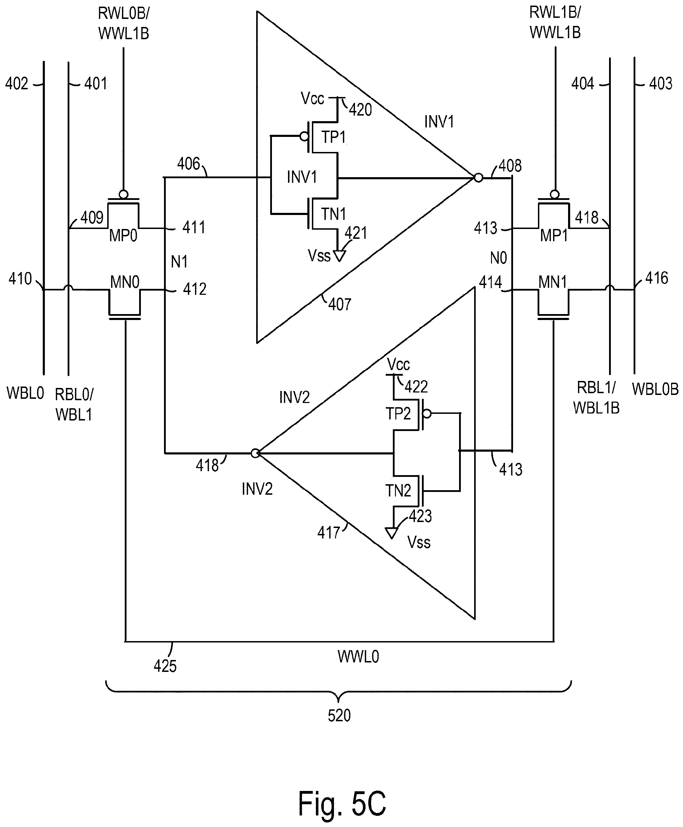

FIG. 5C depicts an example circuit diagram of an 8T SRAM memory cell 520 with a 2 read, 2 write configuration, where a write port includes MN0 and MN1 and read ports include MP0 and MP1, in accordance with various embodiments. The bit line 402 is used for WBL0, the bit line 401 is used for RBL0 or WBL1, the bit line 404 is used for RBL1 or WBL1B, the bit line 403 is used for WBL0B, RWLOB or WWL1B is coupled to the control gate of MP0, RWL1B or WWL1B is coupled to the control gate of MP1, and the word line 425 is used for WLL0.

A single-ended read occurs through a) RWLOB and RBL0 and b) RWL1B and RBL1. A first differential write occurs through a) WWL0 and WBL0/WBL0B. A second differential write occurs through b) WWL1B and WBL1/WBL1B. The read operations (a) and (b) and write b) cannot occur in parallel.

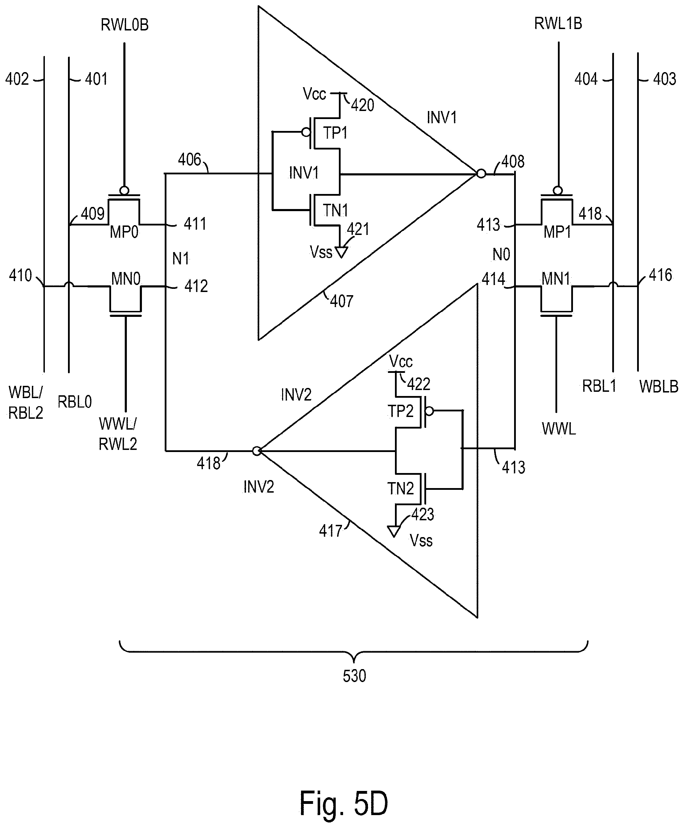

FIG. 5D depicts an example circuit diagram of an 8T SRAM memory cell 530 with a 3 read, 1 write configuration, where write ports includes MN0 and MN1 and read ports include MP0, MP1 and MN0, in accordance with various embodiments. The bit line 402 is used for WBL or RBL2, the bit line 401 is used for RBL0, the bit line 404 is used for RBL1, the bit line 403 is used for WBLB, RWLOB is coupled to the control gate of MP0, RWL1B is coupled to the control gate of MP1, WWL or RWL2 is coupled to the control gate of MN0, and WWL is coupled to the control gate of MN1.

Single-ended reads occur through a) RWLOB and RBL0, b) RWL1B and RBL1 and c) RWL2 and RBL2. A differential write occurs through WWL and WBL/WBLB. The read c) and the write cannot occur in parallel.

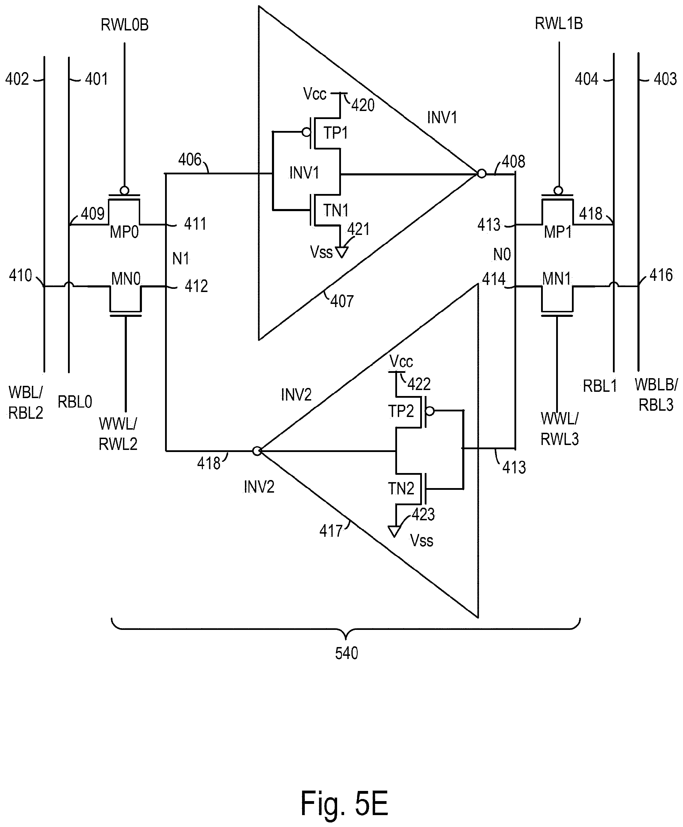

FIG. 5E depicts an example circuit diagram of an 8T SRAM memory cell 540 with a 4 read, 1 write configuration, where write ports includes MN0 and MN1 and read ports include MP0, MP1, MN0 and MN1, in accordance with various embodiments. The bit line 402 is used for WBL or RBL2, the bit line 401 is used for RBL0, the bit line 404 is used for RBL1, the bit line 403 is used for WBLB or RBL2, RWLOB is coupled to the control gate of MP0, RWL1B is coupled to the control gate of MP1, WWL or RWL2 is coupled to the control gate of MN0, and WWL or RWL3 is coupled to the control gate of MN1. RWL0-RWL3 are first through fourth read word lines, respectively, and RBL0-RBL3 are first through fourth read bit lines, respectively.

Single-ended reads occur through a) RWLOB and RBL0, b) RWL1B and RBL1, c) RWL2 and RBL2 and d) RWL3 and RBL3. A differential write occurs through WWL and WBL/WBLB. Reads c) or d) and write cannot occur in parallel.

FIG. 6 depicts an example table of word line and bit line voltages for write, read and retention operations in the SRAM cells 400 (comparative or comp.) and 500 (proposed) of FIGs. 4 and 5A, respectively, in accordance with various embodiments. The table provides a comparison of polarities of WBL and WBLB, WWLB/WWL, RBL0 and RWL0/RWL0B, RBL1 and RWL1/RWL1B between two CFET compatible 2R1W designs for write, read and retention operations.

The voltages are either 0 V or Vcc. Case "A" represents the cell 400 and case "B" represents the cell 500. For WriteO and Write1, WBL and WBLB are the same for cases A and B, but the voltages differ for cases A and B for the other word lines/bit lines. For BL0: Read1, RBL0 is the same (0 V) for cases A and B, but the voltages differ for cases A and B for the other word lines/bit lines. For BL0: Read0, RBL0 is the same (Vcc) for cases A and B, but the voltages differ for cases A and B for the other word lines/bit lines. For BL1: Read1, RBL1 is the same (0 V) for cases A and B, but the voltages differ for cases A and B for the other word lines/bit lines. For BL1: Read0, RBL1 is the same (Vcc) for cases A and B, but the voltages differ for cases A and B for the other word lines/bit lines. For the retention operation, the voltages differ for cases A and B for each of the word lines/bit lines.

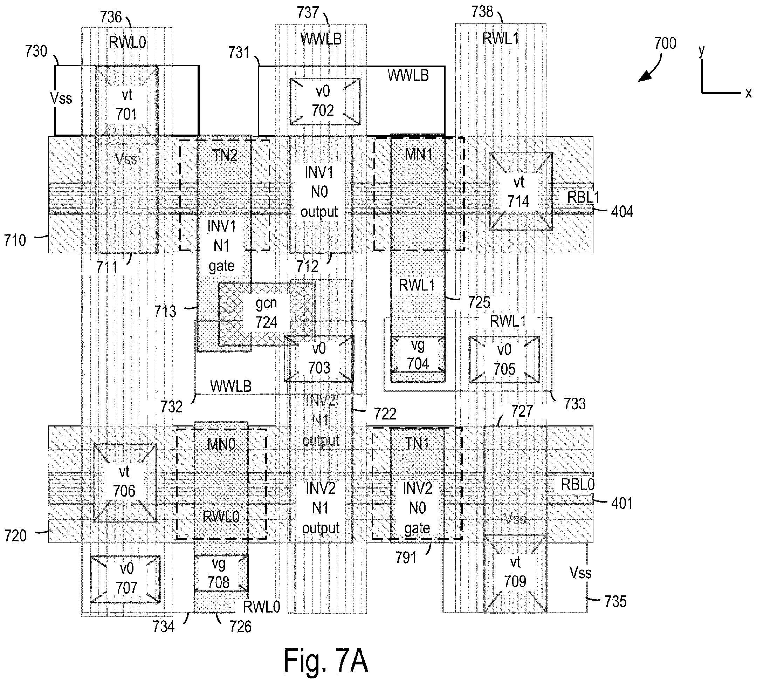

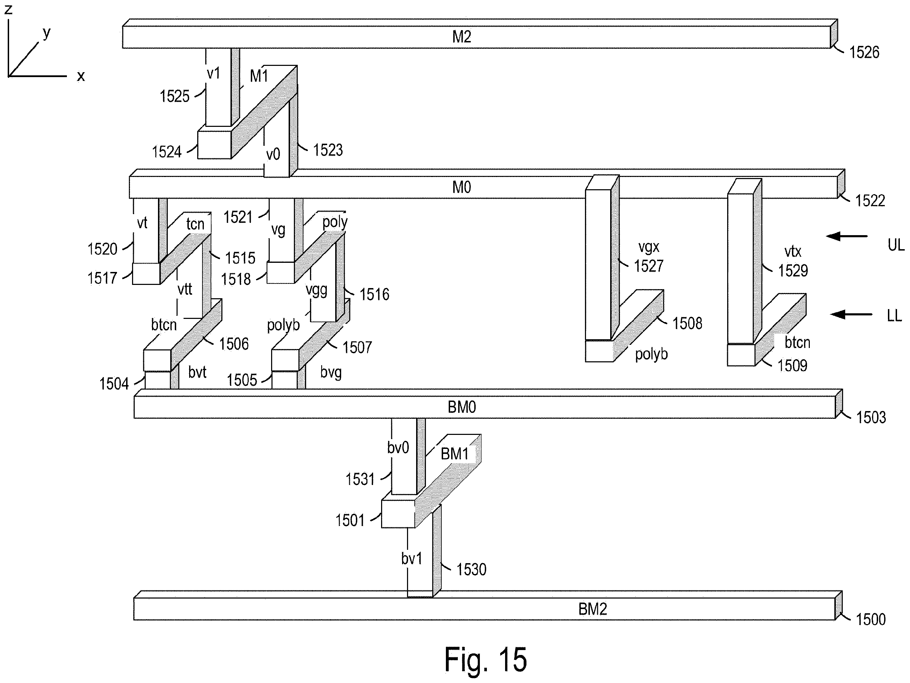

FIG. 7A depicts an example plan view of a front side 700 of an 8T SRAM cell consistent with FIGs. 2 and 4, in accordance with various embodiments. This configuration has the nMOS layer above the pMOS layer. Definitions for the different vias used in the CFET layout are shown in FIG. 15.

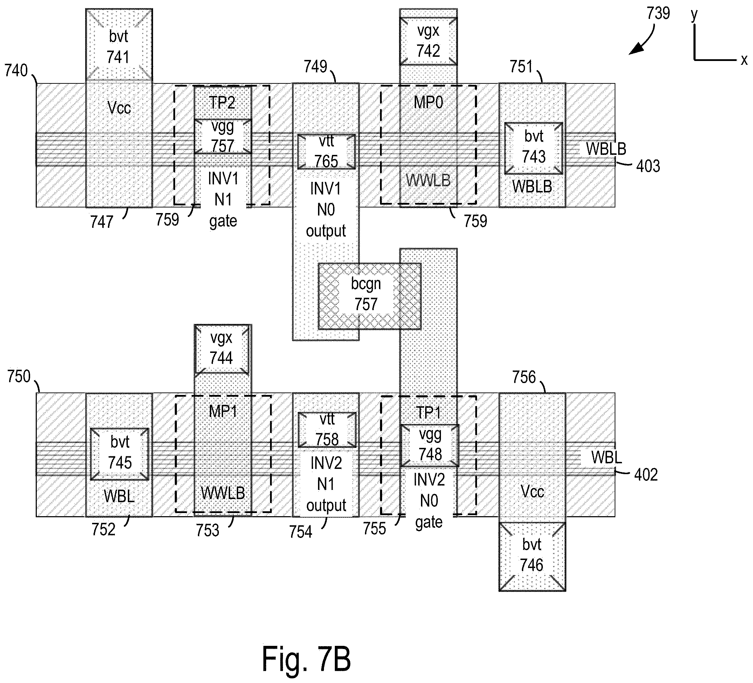

The front side includes a first n-type transistor region 710 with transistors TN2 and MN1, and a second n-type transistor region 720 with transistors MN0 and TN1. Each transistor has laterally opposing source/drain terminals in the n-type transistor region and an overlying control gate. Conductive paths are formed between the transistors and top and bottom metal layers to provide the cell 400 of FIG. 4. Some conductive paths can extend laterally in the plane of the n-type transistor regions (the x-y plane) and can comprise doped polysilicon (poly), for instance. One type of lateral conductive path can extend from an area which overlays a source/drain terminal of a transistor in the n-type transistor region to an area which is external to the n-type transistor region, to provide an area for a via to be located. The via can extend upwards to the M0 or M1 layer, or downwards to the p-type transistor layer of FIG. 7B, for example. Another type of conductive path extends within the n-type layer without contacting a via, to couple the n-type transistor regions 710 and 720.

For example, in the n-type transistor region 710, the conductive path 711 is coupled upward by a via 701 to an M0 portion 730 for Vss.

The conductive path 713 (representing INV1 N1 gate, the control gate of TN2) extends laterally from an area in which it forms a control gate of TN2 to a conductive path 722 (representing INV2 N1 output) which extends from a source/drain terminal of MN0 and TN1. These two conductive paths can be coupled to one another by a gate connect node (gcn) 724 (a poly-to-diffusion gate contact).

The conductive path 712 (representing INV1 NO output) overlays the source/drain terminals of TN2 and MN1 and is coupled downward by a via 765 to a conductive path 749 (FIG. 7B).

The conductive path 725 forms the control gate of MN1 and is coupled upward by the via 704 to an M0 portion 733 for RWL1.

A source/drain terminal of MN1 is coupled upward by the via 714 to an M0 portion for RBL1 404.

In the n-type transistor region 720, a source/drain terminal of NM0 extends upward by the via 706 to an M0 portion for RBL0 401.

The conductive path 726 forms the control gate of MN0 and is coupled upward by the via 708 to an M0 portion 734 for RWL0.

The conductive path 791 (representing INV2 NO gate) forms the control gate of TN1 and is coupled downward by the via 748 to a conductive path 755, which is the control gate of TP1 (FIG. 7B).

The conductive path 727 is coupled upward by a via 709 to an M0 portion 735 for Vss.

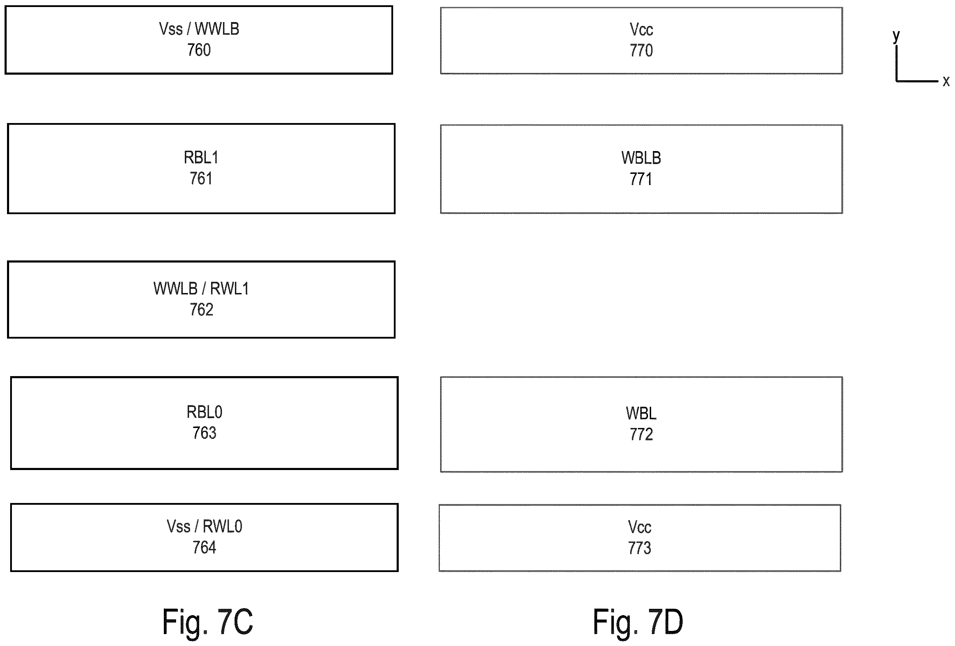

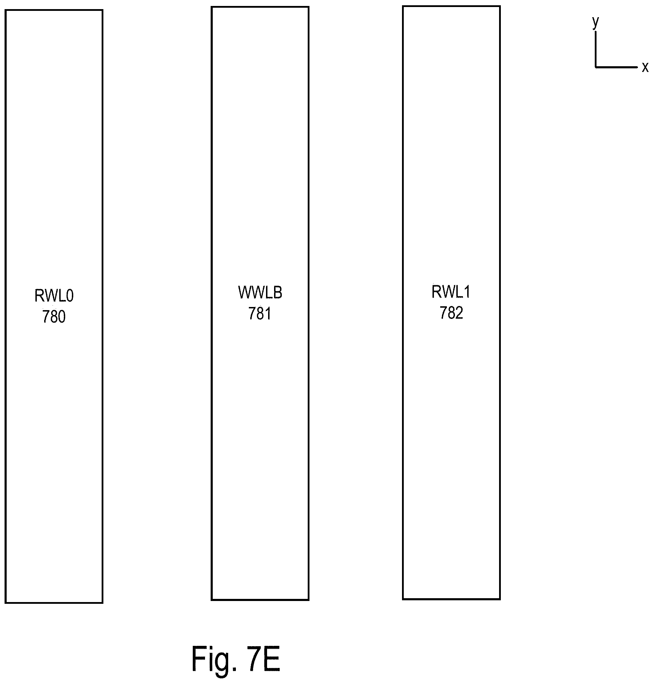

Generally, the vias are conductive paths which extend in the vertical z direction. The vias can include metal plated through-vias, for example, or other conductive material. The vias of the upper layer of the cell can extend upwards to one or more overlying top metal layers, e.g., M0 and M1, such as depicted in FIGs. 7C and 7E, respectively, and FIG. 15. Conductive paths in the one or more top metal layers can be formed to connect vias from the upper layer to one another and/or to control circuits/voltage sources. Additionally, the vias "vt" extend upward from a trench contact node of the n-type transistor region (e.g., a source/drain terminal of a transistor) to M0, the vias "v0" extend upward from M0 to M1, and the vias "vg" extend upward from a gate (poly) to M0. See FIG. 15.

Similarly, the vias of the lower layer of the cell (see FIG. 7B) can extend downwards to one or more underlying bottom metal layers, e.g., BMO and BM1, such as depicted in FIG. 7D and 15. For example, the vias "bvg" extend downwards from a lateral gate (polyb) to BM0. See FIG. 7D. The vias "vgg" extend upward to the upper layer, e.g., through the substrate of the upper layer to contact a lateral conductive path which connects between poly and polyb. This via can extend from a control gate on the lower level to a control gate on the upper level, for instance. The vias "bvt" extend downwards from a source/drain terminal to BM0. The vias "vgx" and "vtx" extend upward to a portion of M0.

Portions of top metal layers M0 and M1 are also depicted. For example, M0 portions 730, 731, 732, 733, 734 and 735 extend in the x direction and denote Vss, WWLB, WWLB, RWL1, RWL0 and Vss, respectively. M1 portions 736, 737 and 738 extend in the y direction and represent RWL0, WWLB and RWL1, respectively.

A conductive path which includes the M1 portion 736 extends down through the via 707 to the M0 portion 734, which in turn extends down through the via 708 to the conductive path 726.

A conductive path which includes the M1 portion 737 extends down through the via 702 to the M0 portion 731, which in turn extends down through the via 742 of FIG. 7B to the conductive path 759.

Another conductive path which includes the M1 portion 737 extends down through the via 703 to the M0 portion 732, which in turn extends down through the via 744 of FIG. 7B to the conductive path 753.

A conductive path which includes the M1 portion 738 extends down through the via 705 to the M0 portion 733, which in turn extends down through the via 704 to the conductive path 725.

FIG. 7B depicts an example plan view of a back side 739 of the SRAM cell consistent with FIGs. 2 and 4 in accordance with various embodiments. The back side includes a first p-type transistor region 740 with transistors TP2 and MP0, and a second p-type transistor region 750 with transistors MP1 and TP1. Each transistor has laterally opposing source/drain terminals in the p-type transistor region and an overlying control gate.

In the p-type transistor region 740, a conductive path 747 at a source/drain terminal of TP2 extends downward by a via 741 to a BMO portion for Vcc.

A conductive path 759 (representing INV1 N1 gate and the control gate of TP2) extends upward by a via 757 to the conductive path 713 of FIG. 7A.

A conductive path 749 (representing INV1 NO output) extends from a source/drain terminal of TP2 and MP0 to a conductive path 755 which extends from a control gate of TP1 (representing INV2 NO gate). These two conductive paths can be coupled to one another by a backside gate connect node (bgcn) 757. The conductive path 749 also extends upwards by a 'vtt' via 765 to the conductive path 712 (FIG. 7A).

A conductive path 759, representing the control gate of MP0, extends upwards by a via 742 to a M0 portion for WWLB.

A conductive path 751 at a source/drain terminal of MP0 extends downward by a via 743 to a BMO portion for WBLB 403.

In the p-type transistor region 750, a conductive path 752 at a source/drain terminal of MP1 extends downward by a via 745 to a BMO portion for WBL 402.

A conductive path 753, representing the control gate of MP1, extends upwards by a via 744 to a M0 portion for WWLB.

A conductive path 754 (representing INV2 N1 output) extends upward by a via 758 to the conductive path 722 of FIG. 7A.

The conductive path 755 extends upwards by a via 748 to the conductive path 791.

A conductive path 756 at a source/drain terminal of TP1 extends downward by a via 746 to a BMO portion for Vcc.

FIG. 7C depicts an example plan view of a first top metal layer M0 of the SRAM cell consistent with FIGs. 2 and 4, in accordance with various embodiments. M0 includes a portion 760 representing Vss or WWLB, a portion 761 representing RBL1, a portion 762 representing WWLB or RWL1, a portion 763 representing RBL0, and a portion 764 representing Vss or RWL0.

FIG. 7D depicts an example plan view of a first bottom metal layer BMO of the SRAM cell consistent with FIGs. 2 and 4, in accordance with various embodiments. BMO includes a portion 770 representing Vcc, a portion 771 representing WBLB, a portion 772 representing WBL, and a portion 773 representing Vcc.

FIG. 7E depicts an example plan view of a second top metal layer M1 of the SRAM cell consistent with FIGs. 2 and 4, in accordance with various embodiments. M1 includes a portion 780 representing RWL0, a portion 781 representing WWLB, and a portion 782 representing RWL1.

In the 2PP (two poly-pitch) version shown in FIG. 7A and 7B, all 4 pMOS transistors are in the back side. The control gates of the write transistors MP0 and MP1 are connected to WWLB through a VGX via from the backside poly (polyb) to the front side M0 and then connected to M1 (in the center of the layout) through a v0 via. The write bit lines WBL and WBLB are routed through the backside M0 (BM0) which is connected from a backside ten (btcn) through the bvt via. Read transistors MN0 and MN1 are activated by RWL0 and RWL1, respectively with RWL0 M1 routing on the left side of the cell and RWL1 M1 routing on the right side of the cell, and they are connected to MN0 and MN1 through a vg via followed by M0 and then by a v0 via to M1. The corresponding RBL0 and RBL1 are routed in M0. The cross-coupled N1 connection is enabled through a front side gcn between the front side poly and front side ten (trench contact).

Another cross-coupled connection NO is enabled through a back side gcn, or bgcn, between the back side poly and btcn. A benefit of the cell is that the highest metal layer used in the front side is M1 and the highest metal layer used in the back side is BM0. WBL and WBLB are routed in BMO which results in higher capacitance. This results in high power dissipation during the write operation. RBL0 and RBL1 are routed in M0, which results in smaller capacitance and therefore lower read power dissipation.

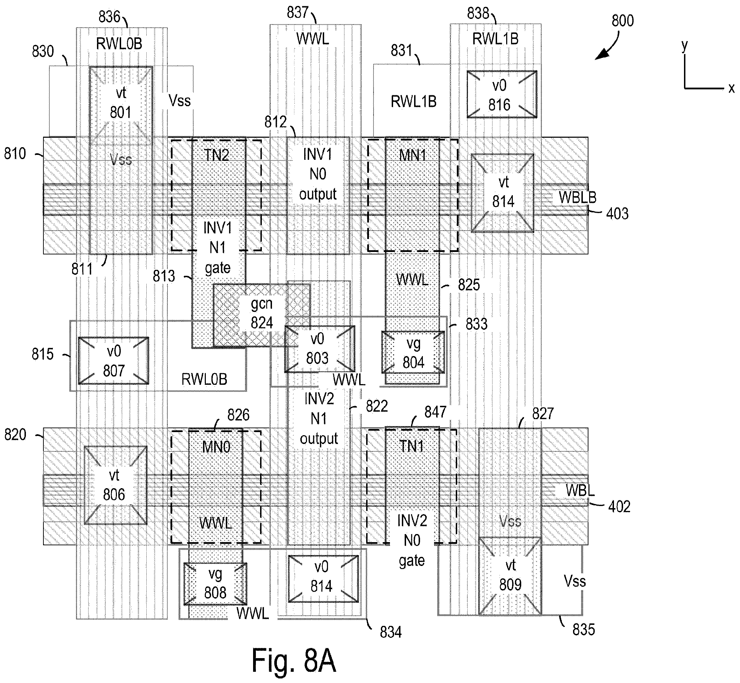

FIG. 8A depicts an example plan view of a front side 800 of an 8T SRAM cell consistent with FIGs. 2 and 5A, in accordance with various embodiments. As mentioned, FIG. 5A differs from FIG. 4 in the driving of the transistors MP0, MP1, MN0 and MN1. In particular, the first and second n-type transistors, MN0 and MN1, respectively, are commonly driven as the write port, and the first and second p-type transistors, MP0 and MP1, respectively, are separately driven as the read ports.

The front side includes a first n-type transistor region 810 with transistors TN2 and MN1, and a second n-type transistor region 820 with transistors MN0 and TN1. Conductive paths are formed between the transistors and top and bottom metal layers to provide the cell 500 of FIG. 5A.

In the n-type transistor region 810, the conductive path 811 is coupled upward by a via 801 to an M0 portion 830 for Vss.

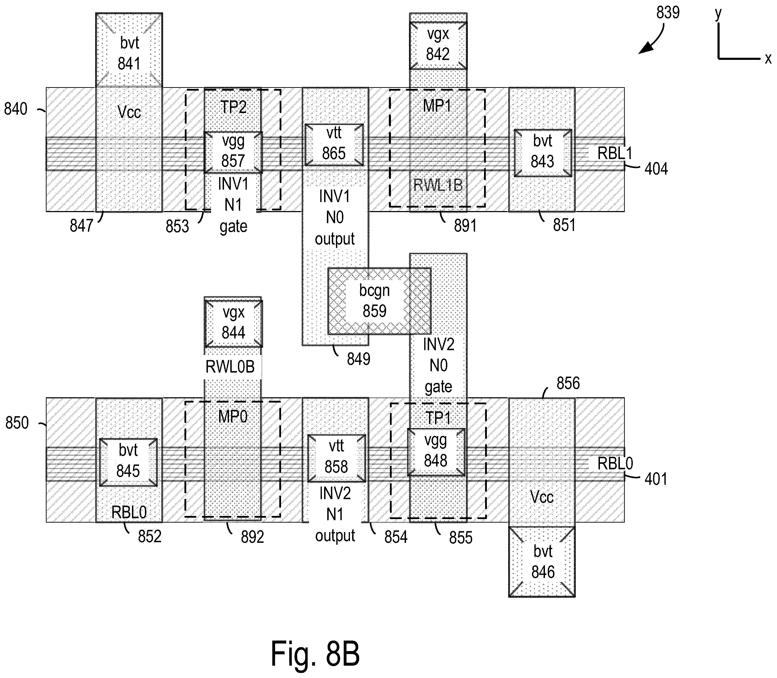

The conductive path 813 (representing INV1 N1 gate) extends laterally from an area in which it forms a control gate of TN2 to a conductive path 822 (representing INV2 N1 output) which extends from a source/drain terminal of MN0 and TN1. These two conductive paths can be coupled to one another by a gcn 824. The conductive path 813 is also coupled downward by a via 857 to a conductive path 853 which forms a control gate of TP2 (FIG. 8B).

The conductive path 812 (representing INV1 NO output) overlays the source/drain terminals of TN2 and MN1 and is coupled downward by a via 865 to a conductive path 849 (FIG. 8B).

The conductive path 825 forms the control gate of MN1 and is coupled upward by the via 804 to an M0 portion 833 for WWL.

A source/drain terminal of MN1 is coupled upward by the via 814 to an M0 portion for WBLB 403.

In the n-type transistor region 820, a source/drain terminal of NM0 extends upward by the via 806 to an M0 portion for WBL 402.

The conductive path 826 forms the control gate of MN0 and is coupled upward by the via 808 to an M0 portion 834 for WWL.

The conductive path 847 (representing INV2 NO gate) forms the control gate of TN1 and is coupled downward by the via 848 to a conductive path 855, which is the control gate of TP1 (FIG. 8B).

The conductive path 827 is coupled upward by a via 809 to an M0 portion 835 for Vss.

M0 portions 830, 831, 815, 833, 834 and 835 extend in the x direction and denote Vss, RWL1B, RWL0B, WWL, WWL and Vss, respectively. M1 portions 836, 837 and 838 extend in the y direction and represent RWL0B, WWL and RWL1B, respectively.

A conductive path which includes the M1 portion 836 extends down through the via 807 to the M0 portion 815, which in turn extends down through the via 844 to the conductive path 892.

A conductive path which includes the M1 portion 837 extends down through the via 814 to the M0 portion 834, which in turn extends down through the via 808 to the conductive path 826.

Another conductive path which includes the M1 portion 837 extends down through the via 803 to the M0 portion 833, which in turn extends down through the via 804 to the conductive path 825.

A conductive path which includes the M1 portion 838 extends down through the via 816 to the M0 portion 831, which in turn extends down through the via 842 to the conductive path 891 in FIG. 8B.

FIG. 8B depicts an example plan view of a back side 839 of the SRAM cell consistent with FIGs. 2 and 5 in accordance with various embodiments. The back side includes a first p-type transistor region 840 with transistors TP2 and MP1, and a second p-type transistor region 850 with transistors MP0 and TP1.

In the p-type transistor region 840, a conductive path 847 at a source/drain terminal of TP2 extends downward by a via 841 to a BMO portion for Vcc.

A conductive path 853 (representing INV1 N1 gate, the control gate of TP2) extends upward by a via 857 to the conductive path 813 of FIG. 8A.

A conductive path 849 (representing INV1 NO output) extends from a source/drain terminal of TP2 and MP1 to a conductive path 855 which extends from a control gate of TP1 (representing INV2 NO gate). These two conductive paths can be coupled to one another by a bgcn 859. The conductive path 849 also extends upwards by a via 865 to the conductive path 812 (FIG. 8A).

A conductive path 891, representing the control gate of MP1, extends upwards by a via 842 to the M0 portion 831 for RWL1B.

A conductive path 851 at a source/drain terminal of MP1 extends downward by a via 843 to a BMO portion for RBL1 404.

In the p-type transistor region 850, a conductive path 852 at a source/drain terminal of MP0 extends downward by a via 845 to a BMO portion for RBL0 401.

A conductive path 892, representing the control gate of MP0, extends upwards by a via 844 to a M0 portion 815 for RWLOB.

A conductive path 854 (representing INV2 N1 output) extends upward by a via 858 to the conductive path 822 of FIG. 8A.

The conductive path 855 extends upwards by a via 848 to the conductive path 847 (FIG. 8A).

A conductive path 856 at a source/drain terminal of TP1 extends downward by a via 846 to a BMO portion for Vcc.

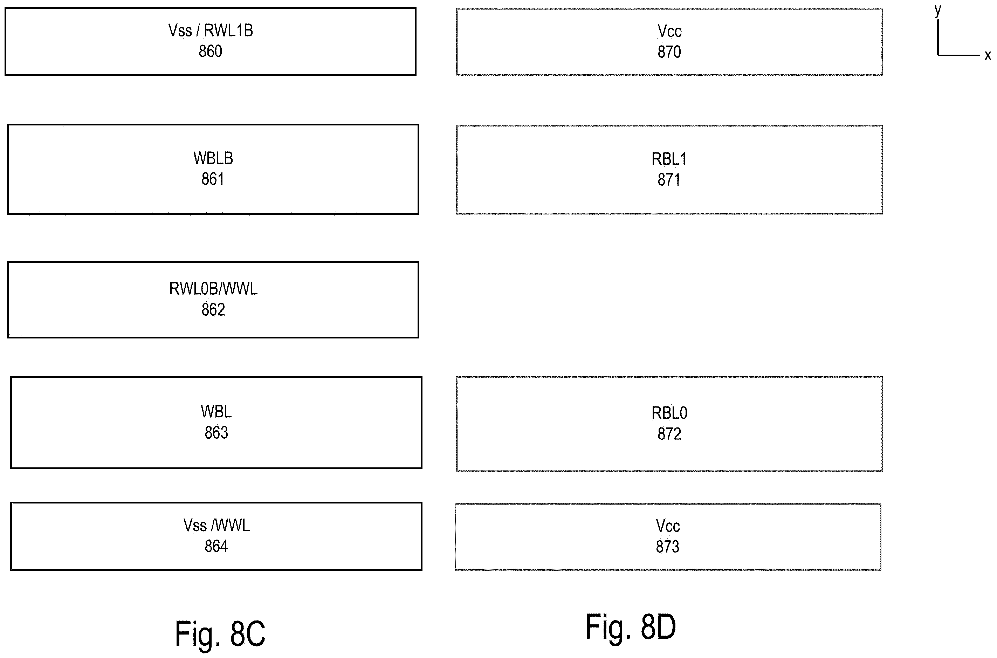

FIG. 8C depicts an example plan view of an M0 layer of the SRAM cell consistent with FIGs. 2 and 5A, in accordance with various embodiments. M0 includes a portion 860 representing Vss/RWL1B, a portion 861 representing WBLB, a portion 862 representing RWL0B/WWL, a portion 863 representing WBL, and a portion 864 representing Vss/WWL.

FIG. 8D depicts an example plan view of a BMO layer of the SRAM cell consistent with FIGs. 2 and 5A, in accordance with various embodiments. BMO includes a portion 870 representing Vcc, a portion 871 representing RBL1, a portion 872 representing RBL0, and a portion 873 representing Vcc.

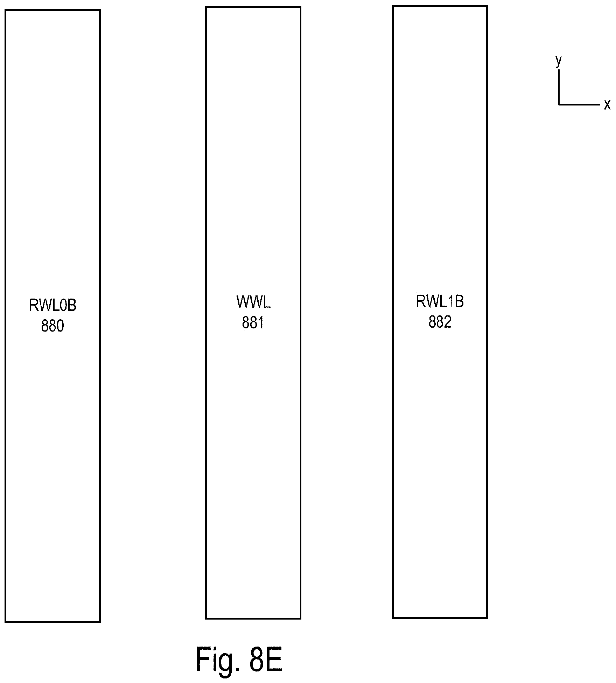

FIG. 8E depicts an example plan view of an M1 layer of the SRAM cell consistent with FIGs. 2 and 5A, in accordance with various embodiments. M1 includes a portion 880 representing RWL0B, a portion 881 representing WWL, and a portion 882 representing RWL1B.

In the proposed 2PP version shown in FIGs. 8A and 8B, all four pMOS transistors are in the back side (BS). The control gates of write transistors MN0 and MN1 are connected to WWL through a vg via from poly to front side M0 and then connected to M1 (in the center of the layout) through a v0 via. The write bit lines WBL and WBLB are routed through M0, which is connected from tcn through the vt via. Read transistors MP0 and MP1 are activated by RWLOB and RWL1B, respectively with RWLOB M1 routing on the left side of the cell and RWL1B M1 routing on the right side of the cell, and they are connected to MP0 and MP1 through a vgx via followed by M0 and then by a v0 via to M1. The corresponding RBL0 and RBL1 are routed in backside M0 (BM0). The cross-coupled N1 connection is enabled through a front side gcn between front side poly and front side tcn. Another cross-coupled connection NO is enabled through a back side gcn, or bgcn, between back side poly and btcn. WBL and WBLB are routed in M0, which results in lower capacitance and therefore lower power dissipation during the write operation. RBL0 and RBL1 are routed in BM0, which results in higher capacitance and therefore higher read power dissipation.

Variants in SRAM and radio frequency (RF) topologies and usage with Architecture-Technology Co-optimization (ATCO) are discussed. SRAM, dual-port SRAM, 1R1W, and 2R1W Register Files (RF) are four primarily bit cells and compiler solutions. In the CFET process with split-gate technology, all four bit cells can be implemented using the same proposed balanced nMOS-pMOS (balanced NP) bit cell topology with the same area footprint. Along with that, 2R1W (differential read), 2R2W, 3R1W and 4R1W can also be implemented with similar topology with some simultaneous access constraints. Hence the proposed solutions are very scalable. To meet power, performance and area (PPA) and leakage goals, balanced NP SRAM (single and dual port) transistors may be targeted to HVT (High voltage threshold) whereas 1R1W and 2R1W RF should follow SVT (standard threshold voltage threshold) process targeting. Iso-bit cell area with different port counts along with different power-performance-array efficiency design points will open an avenue to optimize the cache memory hierarchy for better power-bandwidth tradeoff. For example, all the banked arrays to increase parallel access with banking constraints can be reconstructed with a true multi-ported solution without any additional logic area or power cost. This ATCO will set a path to increase core performance at the same or lower area budget than legacy bit cells due to the scalability of the proposed solutions.

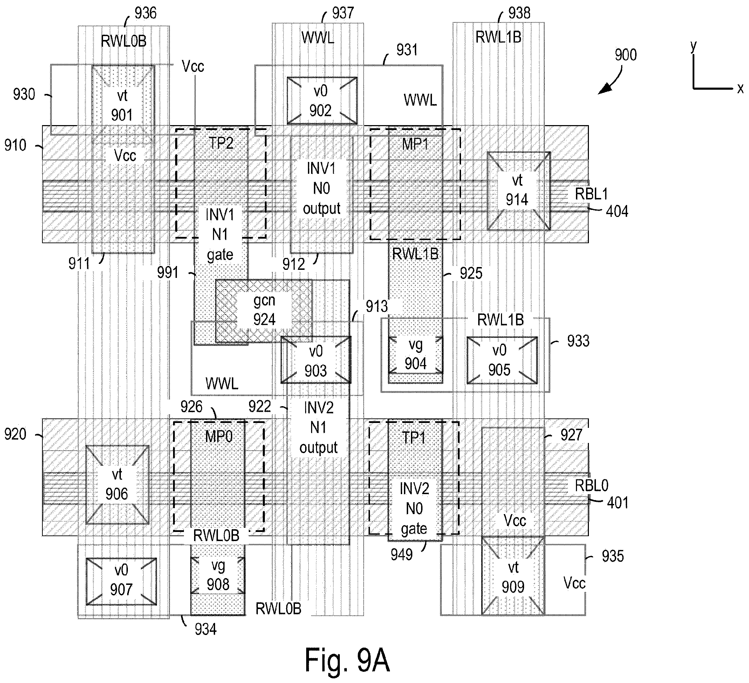

FIG. 9A depicts an example plan view of a front side 900 of an 8T SRAM cell consistent with FIGs. 3 and 5A, in accordance with various embodiments. In this case, the p-type layer is above the n-type layer. The front side includes a first p-type transistor region 910 with transistors TP2 and MP1, and a second p-type transistor region 920 with transistors MP0 and TP1. Conductive paths are formed between the transistors and top and bottom metal layers to provide the cell 500 of FIG. 5A.

In the p-type transistor region 910, the conductive path 911 is coupled upward by a via 901 to an M0 portion 930 for Vcc.

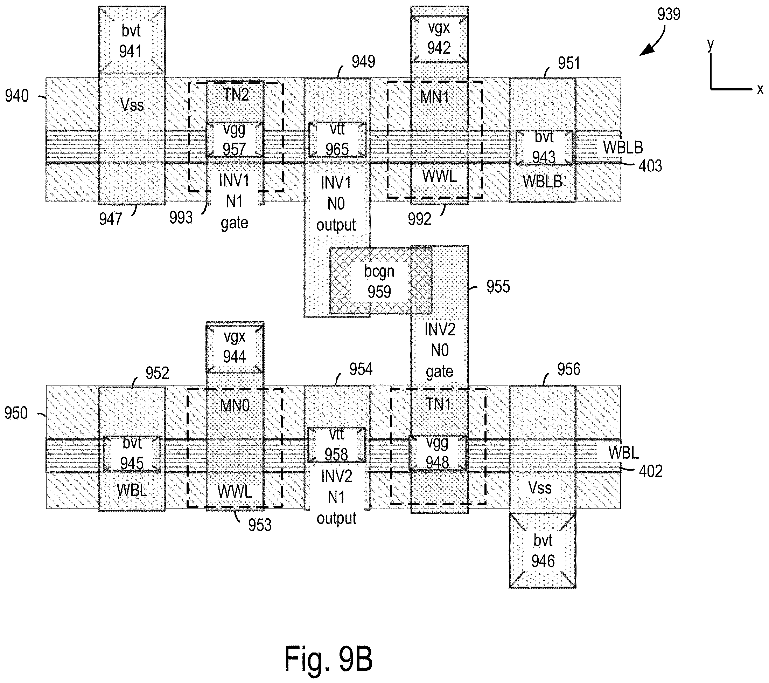

The conductive path 991 (representing INV1 N1 gate) extends laterally from an area in which it forms a control gate of TP2 to a conductive path 922 (representing INV2 N1 output) which extends from a source/drain terminal of MP0 and TP1. These two conductive paths can be coupled to one another by a gcn 924. The conductive path 991 is also coupled downward by a via 957 to a conductive path 991 which forms a control gate of TN2 (FIG. 9B).

The conductive path 912 (representing INV1 NO output) overlays the source/drain terminals of TP2 and MP1 and is coupled downward by a via 965 to a conductive path 949 (FIG. 9B).

The conductive path 925 forms the control gate of MP1 and is coupled upward by the via 904 to an M0 portion 933 for RWL1B.

A source/drain terminal of MP1 is coupled upward by the via 914 to an M0 portion for RBL1 404.

In the p-type transistor region 920, a source/drain terminal of MP0 extends upward by the via 906 to an M0 portion 934 for RBL0 402.

The conductive path 926 forms the control gate of MP0 and is coupled upward by the via 908 to an M0 portion 934 for RWLOB.

The conductive path 922 at the source/drain terminal of MP0 and TP1 (representing INV2 N1 output) is coupled downward by the via 958 to a conductive path 954, which is the control gate of TP1 (FIG. 9B).

The conductive path 949 (representing INV2 NO output) at the control gate of TP1 is coupled downward by the via 948 to a conductive path 955.

The conductive path 927 is coupled upward by a via 909 to an M0 portion 935 for Vcc.

M0 portions 930, 931, 913, 933, 934 and 935 extend in the x direction and denote Vcc, WWL, WWL, RWL1B, RWLOB and Vcc, respectively. M1 portions 936, 937 and 938 extend in the y direction and represent RWL0B, WWL and RWL1B, respectively.

A conductive path which includes the M1 portion 936 extends down through the via 907 to the M0 portion 934, which in turn extends down through the via 908 to the conductive path 926.

A conductive path which includes the M1 portion 937 extends down through the via 902 to the M0 portion 931, which in turn extends down through the via 942 to the conductive path 992.

Another conductive path which includes the M1 portion 937 extends down through the via 903 to the M0 portion 913, which in turn extends down through the via 944 to the conductive path 953.

A conductive path which includes the M1 portion 938 extends down through the via 905 to the M0 portion 933, which in turn extends down through the via 904 to the conductive path 925.

FIG. 9B depicts an example plan view of a back side 939 of the SRAM cell consistent with FIGs. 3 and 5 in accordance with various embodiments. The back side includes a first n-type transistor region 940 with transistors TN2 and MN1, and a second n-type transistor region 950 with transistors MN0 and TN2.

In the n-type transistor region 940, a conductive path 947 at a source/drain terminal of TN2 extends downward by a via 941 to a BMO portion for Vss.

A conductive path 993 (representing INV1 N1 gate, the control gate of TN2) extends upward by a via 957 to the conductive path 991 of FIG. 9A.

A conductive path 949 (representing INV1 NO output) extends from a source/drain terminal of TN2 and MN1 to a conductive path 955 which extends from a control gate of TN1 (representing INV2 NO gate). These two conductive paths can be coupled to one another by a bgcn 959. The conductive path 949 also extends upwards by a via 965 to the conductive path 912 (FIG. 9A).

A conductive path 992, representing the control gate of MN1, extends upwards by a via 942 to a M0 portion 931 for WWL.

A conductive path 951 at a source/drain terminal of MN1 extends downward by a via 943 to a BMO portion for WBLB 403.

In the n-type transistor region 950, a conductive path 952 at a source/drain terminal of NM0 extends downward by a via 945 to a BMO portion for WBL 402.

A conductive path 953, representing the control gate of MN0, extends upwards by a via 944 to a M0 portion 913 for WWL.

A conductive path 954 (representing INV2 N1 output) extends upward by a via 958 to the conductive path 922 of FIG. 9A.

The conductive path 955 extends upwards by a via 948 to the conductive path 949 (FIG. 9A).

A conductive path 956 at a source/drain terminal of T`N1 extends downward by a via 946 to a BMO portion for Vss.

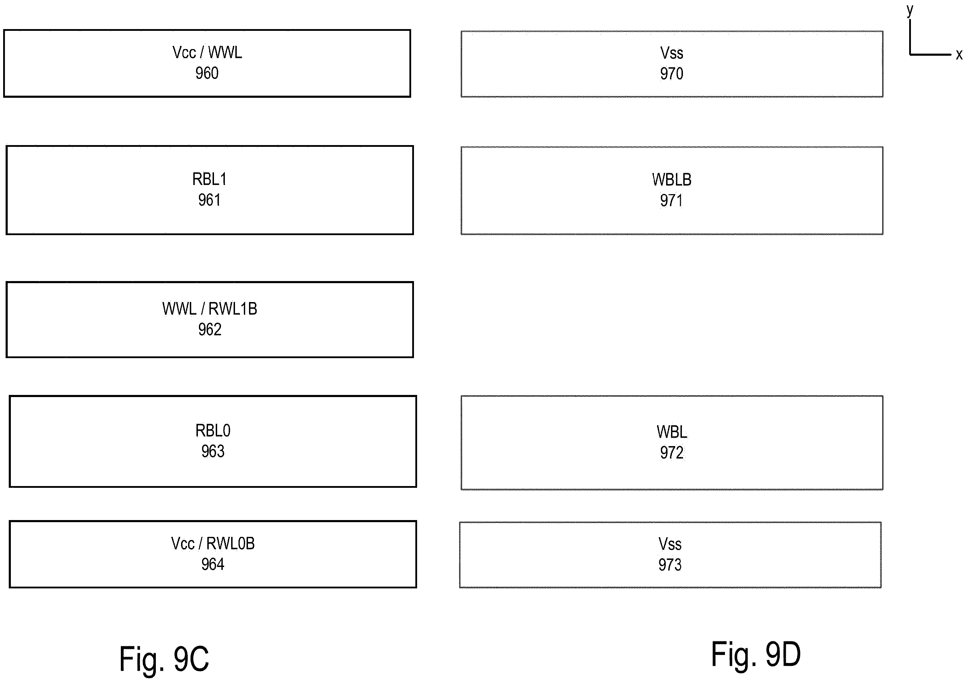

FIG. 9C depicts an example plan view of an M0 layer of the SRAM cell consistent with FIGs. 3 and 5A, in accordance with various embodiments. M0 includes a portion 960 representing Vcc/WWL, a portion 961 representing RBL1, a portion 962 representing WWL /RWL1B, a portion 963 representing RBL0, and a portion 964 representing Vcc/RWL0B.

FIG. 9D depicts an example plan view of a BMO layer of the SRAM cell consistent with FIGs. 3 and 5A, in accordance with various embodiments. BMO includes a portion 970 representing Vss, a portion 971 representing WBLB, a portion 972 representing WBL, and a portion 973 representing Vss.

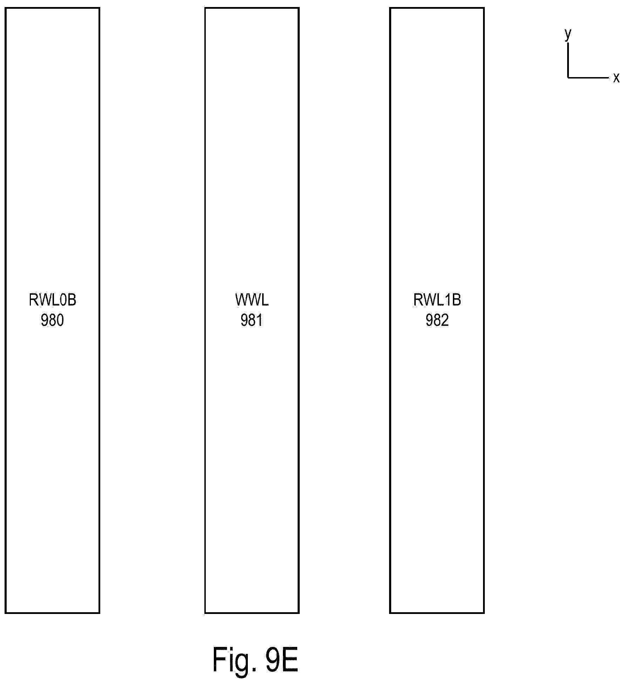

FIG. 9E depicts an example plan view of an M1 layer of the SRAM cell consistent with FIGs. 3 and 5A, in accordance with various embodiments. M1 includes a portion 980 representing RWL0B, a portion 981 representing WWL, and a portion 982 representing RWL1B.

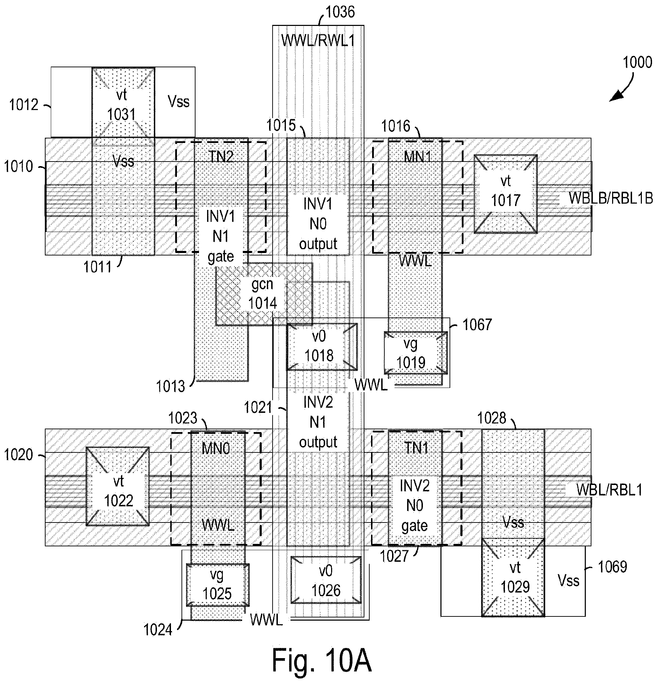

FIG. 10A depicts an example plan view of a front side 1000 of an 8T SRAM cell consistent with FIGs. 3 and 5B, in accordance with various embodiments.

The front side includes a first n-type transistor region 1010 with transistors TN2 and MN1, and a second n-type transistor region 1020 with transistors MN0 and TN1. Conductive paths are formed between the transistors and top and bottom metal layers to provide the cell 510 of FIG. 5B.

In the n-type transistor region 1010, the conductive path 1011 is coupled upward by a via 1031 to an M0 portion 1012 for Vss.

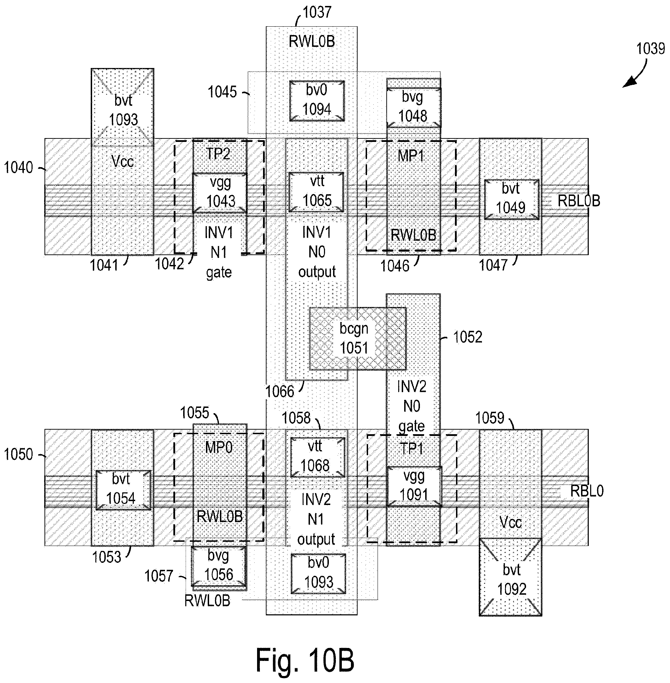

The conductive path 1013 (representing INV1 N1 gate) extends laterally from an area in which it forms a control gate of TN2 to a conductive path 1021 (representing INV2 N1 output) which extends from a source/drain terminal of MN0 and TN1. These two conductive paths can be coupled to one another by a gcn 1014. The conductive path 1013 is also coupled downward by a via 1043 to a conductive path 1042 which forms a control gate of TP2 (FIG. 10B).

The conductive path 1015 (representing INV1 NO output) overlays the source/drain terminals of TN2 and MN1 and is coupled downward by a via 1065 to a conductive path 1066 (FIG. 10B).

The conductive path 1016 forms the control gate of MN1 and is coupled upward by the via 1019 to an M0 portion 1067 for WWL.

A source/drain terminal of MN1 is coupled upward by the via 1017 to an M0 portion for WBLB/RBL1B.

In the n-type transistor region 1020, a source/drain terminal of MN0 extends upward by the via 1022 to an M0 portion for WBL/RBL1.

The conductive path 1023 forms the control gate of MN0 and is coupled upward by the via 1025 to an M0 portion 1024 for WWL.

The conductive path 1021 (representing INV2 N1 output) is coupled downward by the via 1068 to a conductive path 1058 (FIG. 10B).

The conductive path 1027 is coupled downward by a via 1091 to a conductive path 1052 (FIG. 10B).

The conductive path 1028 is coupled upward by a via 1029 to an M0 portion 1069 for Vss.

M0 portions 1012, 1067, 1024 and 1069 extend in the x direction and denote Vss, WWL, WWL and Vss, respectively. M1 portion 1036 extends in the y direction and represents

WWL/RWL1.

A conductive path which includes the M1 portion 1036 extends down through the via 1018 to the M0 portion 1067, which in turn extends down through the via 1018 to the conductive path 1016.

Another conductive path which includes the M1 portion 1036 extends down through the via 1026 to the M0 portion 1024, which in turn extends down through the via 1025 to the conductive path 1023.

FIG. 10B depicts an example plan view of a back side 1039 of the SRAM cell consistent with FIGs. 3 and 5B in accordance with various embodiments. The back side includes a first p-type transistor region 1040 with transistors TP2 and MP1, and a second p-type transistor region 1050 with transistors MP0 and TP1.

In the p-type transistor region 1040, a conductive path 1041 at a source/drain terminal of TP2 extends downward by a via 1093 to a BMO portion for Vcc.

A conductive path 1042 (representing INV1 N1 gate, the control gate of TP2) extends upward by a via 1043 to the conductive path 1013 of FIG. 10A.

A conductive path 1066 (representing INV1 NO output) extends from a source/drain terminal of TP2 and MP1 to a conductive path 1052 which extends from a control gate of TP1 (representing INV2 NO gate). These two conductive paths can be coupled to one another by a bgcn 1051. The conductive path 1066 also extends upwards by a via 1065 to the conductive path 1015 (FIG. 10A).

A conductive path 1046, representing the control gate of MP1, extends upwards by a via 1048 to the M0 portion 1045 for RWLOB.

A conductive path 1047 at a source/drain terminal of MP1 extends downward by a via 1049 to a BMO portion for RBL0B.

In the p-type transistor region 1050, a conductive path 1053 at a source/drain terminal of MP0 extends downward by a via 1054 to a BMO portion for RBL0.

A conductive path 1055, representing the control gate of MP0, extends upwards by a via 1056 to a M0 portion 1057 for RWLOB.

A conductive path 1058 (representing INV2 N1 output) extends upward by a via 1068 to the conductive path 1021 of FIG. 10A.

The conductive path 1052 extends upwards by a via 1091 to the conductive path 1027 (FIG. 10A).

A conductive path 1059 at a source/drain terminal of TN1 extends downward by a via 1092 to a BMO portion for Vcc.

A BM1 portion 1037 is also depicted which represents RWLOB. A conductive path extends from the BM1 portion 1037 upward by the via 1094 to the BMO portion 1045 and from there further upward by the via 1048 to the conductive portion 1046. An additional conductive path extends from the BM1 portion 1037 upward by the via 1093 to the BMO portion 1057 and from there further upward by the via 1056 to the conductive portion 1055.

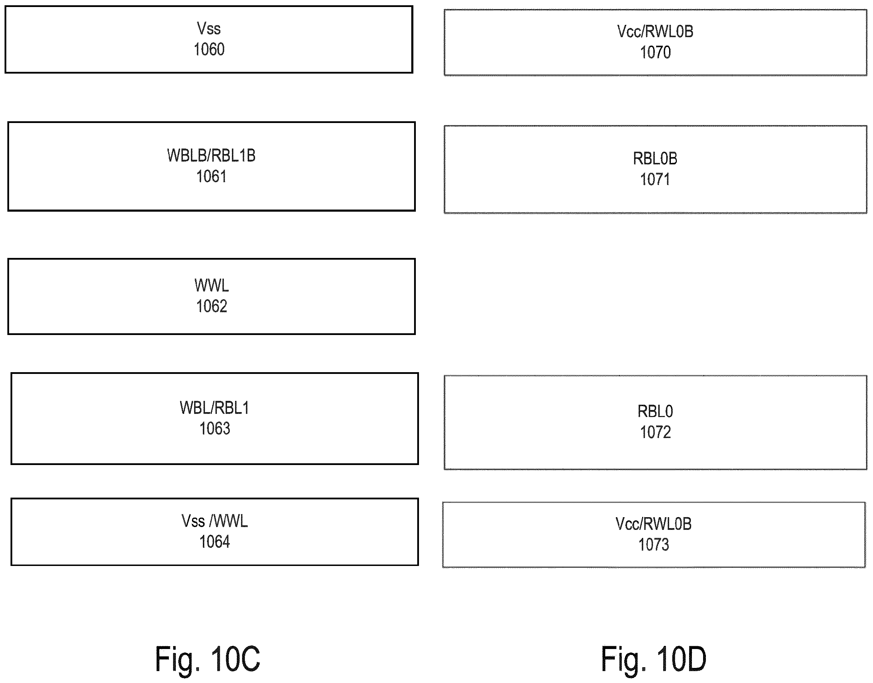

FIG. 10C depicts an example plan view of an M0 layer of the SRAM cell consistent with FIGs. 3 and 5B, in accordance with various embodiments. M0 includes a portion 1060 representing Vss, a portion 1061 representing WBLB/RBL1B, a portion 1062 representing WWL, a portion 1063 representing WBL/RBL1, and a portion 1064 representing Vss/WWL0.

FIG. 10D depicts an example plan view of a BMO layer of the SRAM cell consistent with FIGs. 3 and 5B, in accordance with various embodiments. BMO includes a portion 1070 representing Vcc/RWL0B, a portion 1071 representing RBL0B, a portion 1072 representing RBL0, and a portion 1073 representing Vcc/RWL0B.

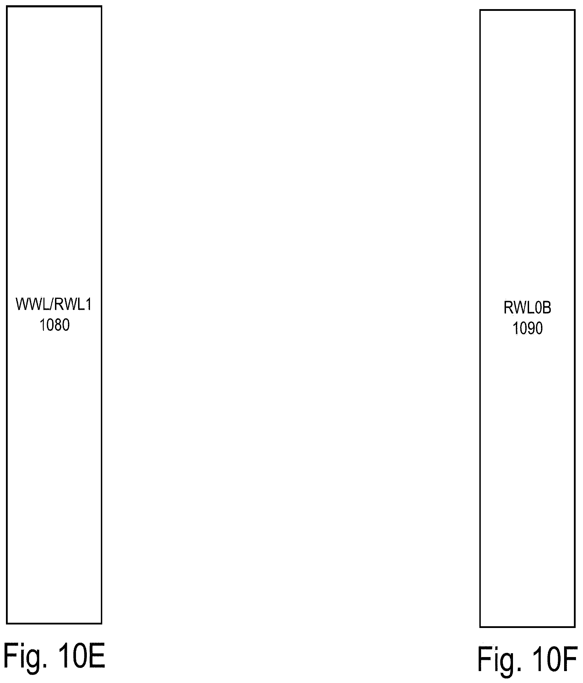

FIG. 10E depicts an example plan view of an M1 layer of the SRAM cell consistent with FIGs. 3 and 5B, in accordance with various embodiments. M1 includes a portion 1080 representing WWL/RWL1.

FIG. 10F depicts an example plan view of a BM1 layer of the SRAM cell consistent with FIGs. 3 and 5B, in accordance with various embodiments. BM1 includes a portion 1090 representing RWLOB.

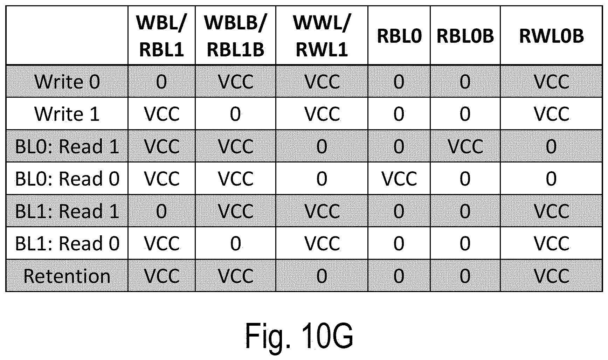

FIG. 10G depicts an example table of word line and bit line voltages for write, read and retention operations in the SRAM cell of FIG. 5B, in accordance with various embodiments. BL1 read operation and write operation cannot happen simultaneously. One operation at a time can be performed.

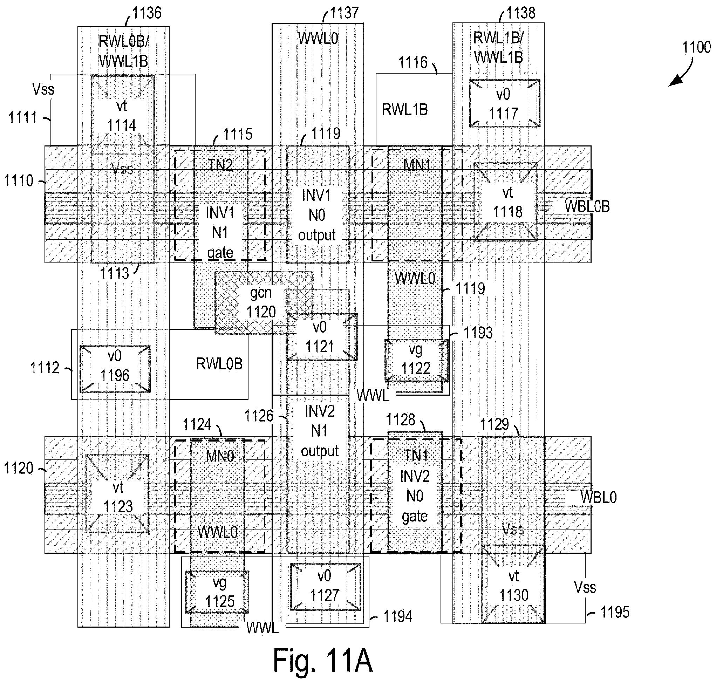

FIG. 11A depicts an example plan view of a front side 1100 of an 8T SRAM cell consistent with FIGs. 3 and 5C, in accordance with various embodiments.

The front side includes a first n-type transistor region 1110 with transistors TN2 and MN1, and a second n-type transistor region 1120 with transistors MN0 and TN1. Conductive paths are formed between the transistors and top and bottom metal layers to provide the cell 520 of FIG. 5C.

In the n-type transistor region 1110, the conductive path 1113 is coupled upward by a via 1114 to an M0 portion 1111 for Vss.

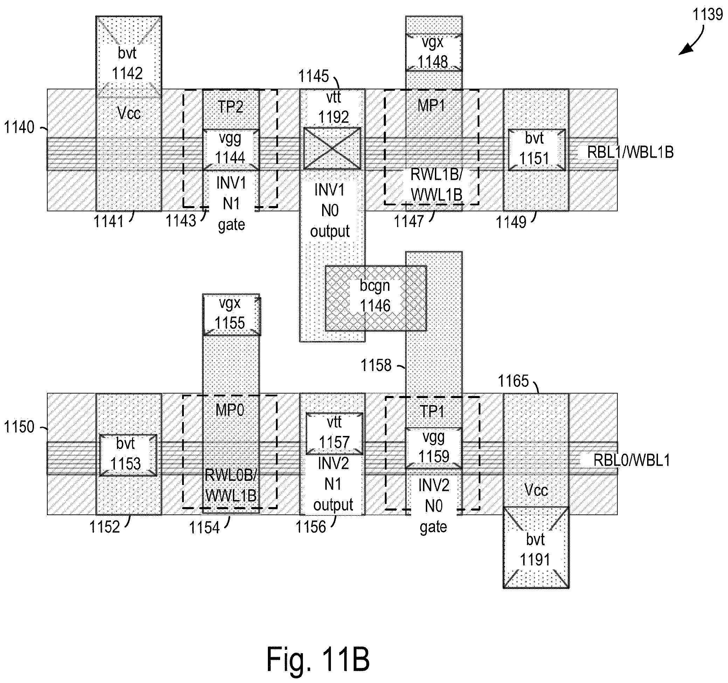

The conductive path 1115 (representing INV1 N1 gate) extends laterally from an area in which it forms a control gate of TN2 to a conductive path 1126 (representing INV2 N1 output) which extends from a source/drain terminal of MN0 and TN1. These two conductive paths can be coupled to one another by a gcn 1120. The conductive path 1119 is also coupled downward by a via 1144 to a conductive path 1143 which forms a control gate of TP2 (FIG. 11B).

The conductive path 1119 (representing INV1 NO output) overlays the source/drain terminals of TN2 and MN1 and is coupled downward by a via 1192 to a conductive path 1145 (FIG. 11B).

The conductive path 1119 forms the control gate of MN1 and is coupled upward by the via 1122 to an M0 portion 1193 for WWL.

A source/drain terminal of MN1 is coupled upward by the via 1118 to an M0 portion for WBL0B.

In the n-type transistor region 1120, a source/drain terminal of MN0 extends upward by the via 1123 to an M0 portion for WBL0.

The conductive path 1124 forms the control gate of MN0 and is coupled upward by the via 1125 to an M0 portion 1194 for WWL.

The conductive path 1128 (representing INV2 NO gate) is coupled downward by the via 1159 to a conductive path 1158 (FIG. 11B).

The conductive path 1129 is coupled upward by a via 1130 to an M0 portion 1195 for Vss.

M0 portions 1111, 1116, 1112, 1193, 1194 and 1195 extend in the x direction and denote Vss, RWL1B, RWL0B, WWL, WWL and Vss, respectively. M1 portions 1136, 1137 and 1138 extend in the y direction and represent RWLOB/WWL1B, WWL0 and RWL1B/WWL1B, respectively.

A conductive path which includes the M1 portion 1136 extends down through the via 1196 to the M0 portion 1112, which in turn extends down through the via 1155 to the conductive path 1154.

A conductive path which includes the M1 portion 1137 extends down through the via 1121 to the M0 portion 1193, which in turn extends down through the via 1122 to the conductive path 1119.

Another conductive path which includes the M1 portion 1137 extend down through the via 1127 to the M0 portion 1194, which in turn extends down through the via 1125 to the conductive path 1124.

A conductive path which includes the M1 portion 1138 extends down through the via 1117 to the M0 portion 1116, which in turn extends down through the via 1148 to the conductive path 1147.

FIG. 11B depicts an example plan view of a back side 1139 of the SRAM cell consistent with FIGs. 3 and 5C in accordance with various embodiments. The back side includes a first p-type transistor region 1140 with transistors TP2 and MP1, and a second p-type transistor region 1150 with transistors MP0 and TP1.

In the p-type transistor region 1140, a conductive path 1141 at a source/drain terminal of TP2 extends downward by a via 1142 to a BMO portion for Vcc.

A conductive path 1143 (representing INV1 N1 gate, the control gate of TP2) extends upward by a via 1144 to the conductive path 1115 of FIG. 11A.

A conductive path 1145 (representing INV1 NO output) extends from a source/drain terminal of TP2 and MP1 to a conductive path 1158 which extends from a control gate of TP1 (representing INV2 NO gate). These two conductive paths can be coupled to one another by a bgcn 1146. The conductive path 1145 also extends upwards by a via 1192 to the conductive path 1119 (FIG. 11A).

A conductive path 1147, representing the control gate of MP1, extends upwards by a via 1148 to the M0 portion 1116 for RWL1B.

A conductive path 1149 at a source/drain terminal of MP1 extends downward by a via 1151 to a BMO portion for RBL1/WBL1B.

In the p-type transistor region 1150, a conductive path 1152 at a source/drain terminal of MP0 extends downward by a via 1153 to a BMO portion for RBL0/WBL1.

A conductive path 1154, representing the control gate of MP0, extends upwards by a via 1155 to a M0 portion 1112 for RWLOB.

A conductive path 1156 (representing INV2 N1 output) extends upward by a via 1157 to the conductive path 1126 of FIG. 11A.

The conductive path 1158 extends upwards by a via 1159 to the conductive path 1128 (FIG. 11A).

A conductive path 1165 at a source/drain terminal of TN1 extends downward by a via 1191 to a BMO portion for Vcc.

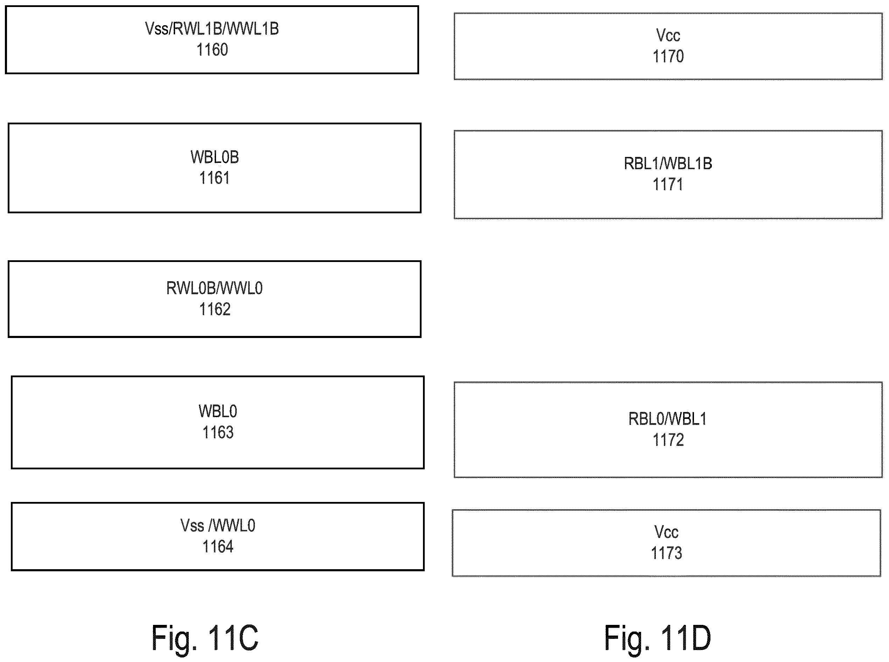

FIG. 11C depicts an example plan view of an M0 layer of the SRAM cell consistent with FIGs. 3 and 5C, in accordance with various embodiments. M0 includes a portion 1160 representing Vss/RWL1B/WWL1B, a portion 1161 representing WBL0B, a portion 1162 representing RWL0B/WWL0, a portion 1163 representing WBL0, and a portion 1164 representing Vss/WWL0.

FIG. 11D depicts an example plan view of a BMO layer of the SRAM cell consistent with FIGs. 3 and 5C, in accordance with various embodiments. BMO includes a portion 1170 representing Vcc, a portion 1171 representing RBL1/WBL1B, a portion 1172 representing RBLO/WBL1, and a portion 1173 representing Vcc.

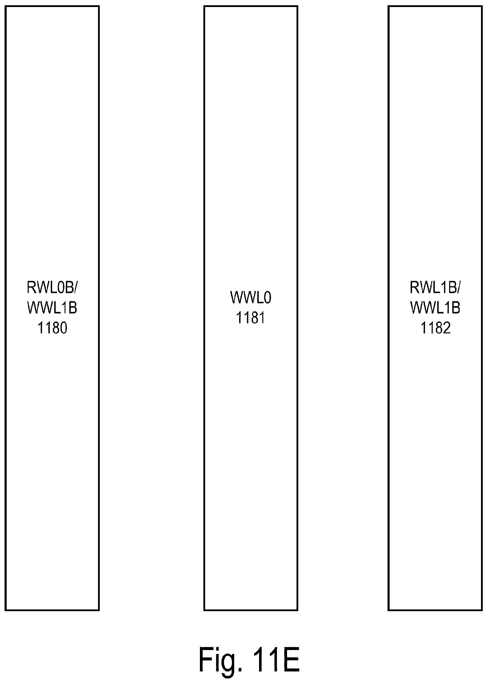

FIG. 11E depicts an example plan view of an M1 layer of the SRAM cell consistent with FIGs. 3 and 5C, in accordance with various embodiments. M1 includes a portion 1180 representing RWL0B/WWL1B, a portion 1181 representing WWL0, and a portion 1182 representing RWL1B/WWL1B.

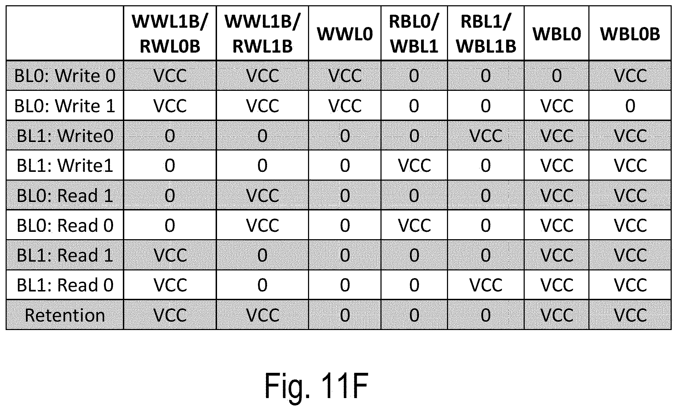

FIG. 11F depicts an example table of word line and bit line voltages for write, read and retention operations in the SRAM cell of FIG. 5C, in accordance with various embodiments. BL1 write operation and read operation BL0 read and BL1 read cannot happen simultaneously. One operation at a time is performed.

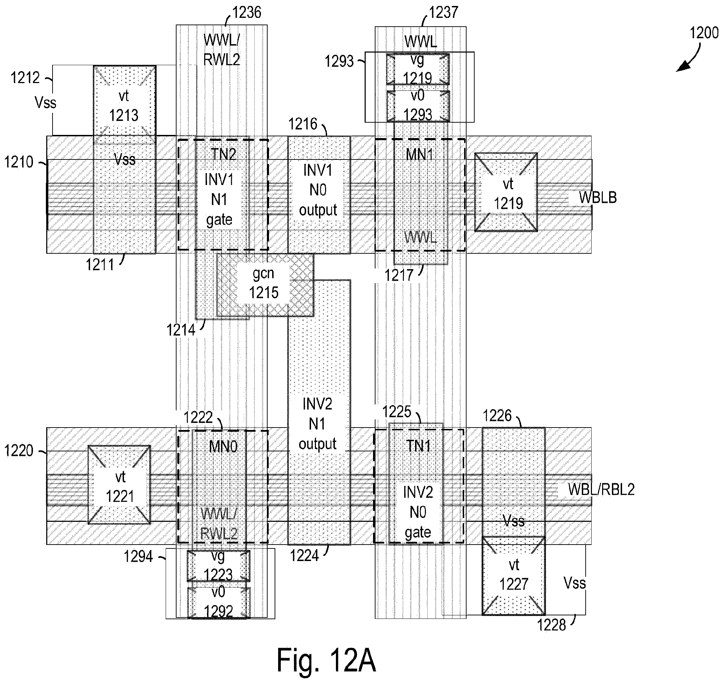

FIG. 12A depicts an example plan view of a front side 1200 of an 8T SRAM cell consistent with FIGs. 3 and 5D, in accordance with various embodiments. The front side includes a first n-type transistor region 1210 with transistors TN2 and MN1, and a second n-type transistor region 1220 with transistors MN0 and TN1. Conductive paths are formed between the transistors and top and bottom metal layers to provide the cell 530 of FIG. 5D.

In the n-type transistor region 1210, the conductive path 1211 is coupled upward by a via 1213 to an M0 portion 1212 for Vss.

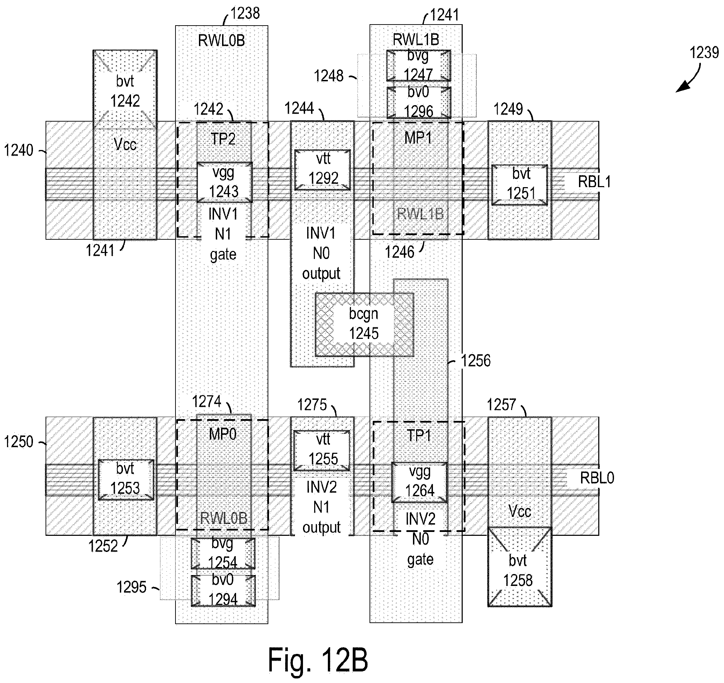

The conductive path 1214 (representing INV1 N1 gate) extends laterally from an area in which it forms a control gate of TN2 to a conductive path 1224 (representing INV2 N1 output) which extends from a source/drain terminal of MN0 and TN1. These two conductive paths can be coupled to one another by a gcn 1215. The conductive path 1214 is also coupled downward by a via 1243 to a conductive path 1242 which forms a control gate of TP2 (FIG. 12B).

The conductive path 1216 (representing INV1 NO output) overlays the source/drain terminals of TN2 and MN1 and is coupled downward by a via 1292 to a conductive path 1244 (FIG. 12B).

The conductive path 1217 forms the control gate of MN1 and is coupled upward by the via 1218 to an M0 portion 1293, and from there upward by the via 1293 to an M1 portion for WWL 1237. The two vias are shown as being laterally offset but could alternatively be directly on top of one another.

A source/drain terminal of MN1 is coupled upward by the via 1219 to an M0 portion for WBLB.

In the n-type transistor region 1220, a source/drain terminal of MN0 extends upward by the via 1221 to an M0 portion for WBL/RBL2.

The conductive path 1222 forms the control gate of MN0 and is coupled upward by the via 1223 to an M0 portion 1294, and from there upward by a via 1292 to an M1 portion for WWL/RWL2.

The conductive path 1225 (representing INV2 NO gate) is coupled downward by the via 1264 to a conductive path 1256 (FIG. 12B).

The conductive path 1226 is coupled upward by a via 1227 to an M0 portion 1228 for Vss.

M0 portions 1212, 1293, 1294 and 1228 extend in the x direction and denote Vss, WWL, WWL/RWL2 and Vss, respectively. M1 portions 1236 and 1237 extend in the y direction and represent WWL/RWL2 and WWL, respectively.

A conductive path which includes the M1 portion 1236 extends down through the via 1292 to the M0 portion 1294, which in turn extends down through the via 1223 to the conductive path 1222.

A conductive path which includes the M1 portion 1237 extends down through the via 1293 to the M0 portion 1293, which in turn extends down through the via 1219 to the conductive path 1217.

FIG. 12B depicts an example plan view of a back side 1239 of the SRAM cell consistent with FIGs. 3 and 5D in accordance with various embodiments. The back side includes a first p-type transistor region 1240 with transistors TP2 and MP1, and a second p-type transistor region 1250 with transistors MP0 and TP1.

In the p-type transistor region 1240, a conductive path 1241 at a source/drain terminal of TP2 extends downward by a via 1242 to a BMO portion for Vcc.

A conductive path 1242 (representing INV1 N1 gate, the control gate of TP2) extends upward by a via 1243 to the conductive path 1214 of FIG. 12A.

A conductive path 1244 (representing INV1 NO output) extends from a source/drain terminal of TP2 and MP1 to a conductive path 1256 which extends from a control gate of TP1 (representing INV2 NO gate). These two conductive paths can be coupled to one another by a bgcn 1245. The conductive path 1244 also extends upwards by a via 1292 to the conductive path 1216 (FIG. 12A).

A conductive path 1246, representing the control gate of MP1, extends downwards by a via 1247 to the BMO portion 1248, and from there further downward by a via 1296 to a BM1 portion for RWL1B 1241.

A conductive path 1249 at a source/drain terminal of MP1 extends downward by a via 1251 to a BMO portion for RBL1.

In the p-type transistor region 1250, a conductive path 1252 at a source/drain terminal of MP0 extends downward by a via 1253 to a BMO portion for RBL0.

A conductive path 1274, representing the control gate of MP0, extends downwards by a via 1254 to a BMO portion 1295 and from there further down by a via 1294 to a BM1 portion for RWLOB 1238.

A conductive path 1275 (representing INV2 N1 output) extends upward by a via 1255 to the conductive path 1224 of FIG. 12A.

The conductive path 1256 extends upwards by a via 1264 to the conductive path 1225 (FIG. 12A).

A conductive path 1257 at a source/drain terminal of T`N1 extends downward by a via 1258 to a BMO portion for Vcc.

BM1 portions 1238 and 1241 are also depicted which represent RWLOB and RWL1B, respectively. A conductive path extends from the BM1 portion 1238 upward by the via 1294 to the BMO portion 1295 and from there further upward by the via 1254 to the conductive portion 1274. A conductive path also extends from the BM1 portion 1241 upward by the via 1296 to the BMO portion 1248 and from there further upward by the via 1247 to the conductive portion 1246.

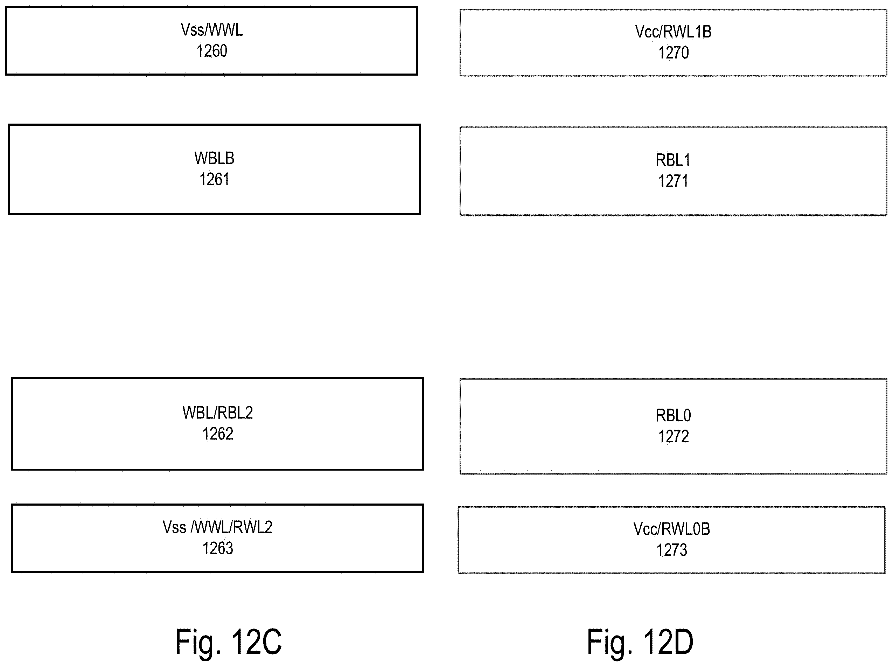

FIG. 12C depicts an example plan view of an M0 layer of the SRAM cell consistent with FIGs. 3 and 5D, in accordance with various embodiments. M0 includes a portion 1260 representing Vss/WWL, a portion 1261 representing WBLB, a portion 1262 representing WBL/RBL2, and a portion 1263 representing Vss/WWL/RWL2.

FIG. 12D depicts an example plan view of a BMO layer of the SRAM cell consistent with FIGs. 3 and 5D, in accordance with various embodiments. BMO includes a portion 1270 representing Vcc/RWL1B, a portion 1271 representing RBL1, a portion 1272 representing RBL0, and a portion 1273 representing Vcc/RWL0B.

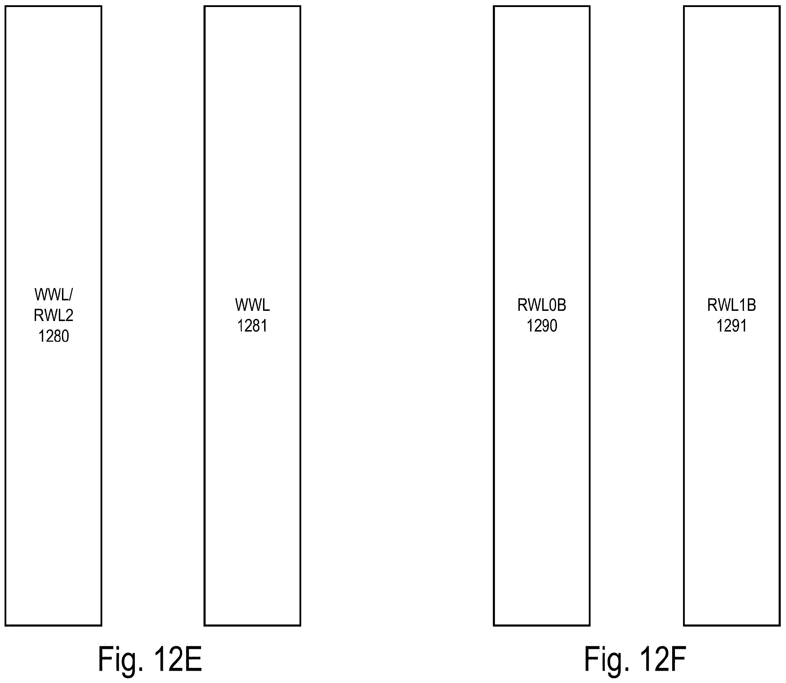

FIG. 12E depicts an example plan view of an M1 layer of the SRAM cell consistent with FIGs. 3 and 5D, in accordance with various embodiments. M1 includes a portion 1280 representing WWL/RWL2 and a portion 1281 representing WWL.

FIG. 12F depicts an example plan view of a BM1 layer of the SRAM cell consistent with FIGs. 3 and 5D, in accordance with various embodiments. BM1 includes a portion 1290 representing RWLOB and a portion 1291 representing RWL1B.

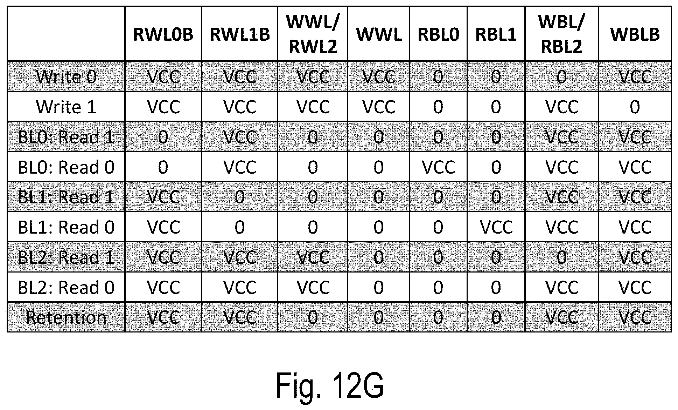

FIG. 12G depicts an example table of word line and bit line voltages for write, read and retention operations in the SRAM cell of FIG. 5D, in accordance with various embodiments. BL2 read operation and a write operation cannot happen simultaneously. One operation at a time is performed

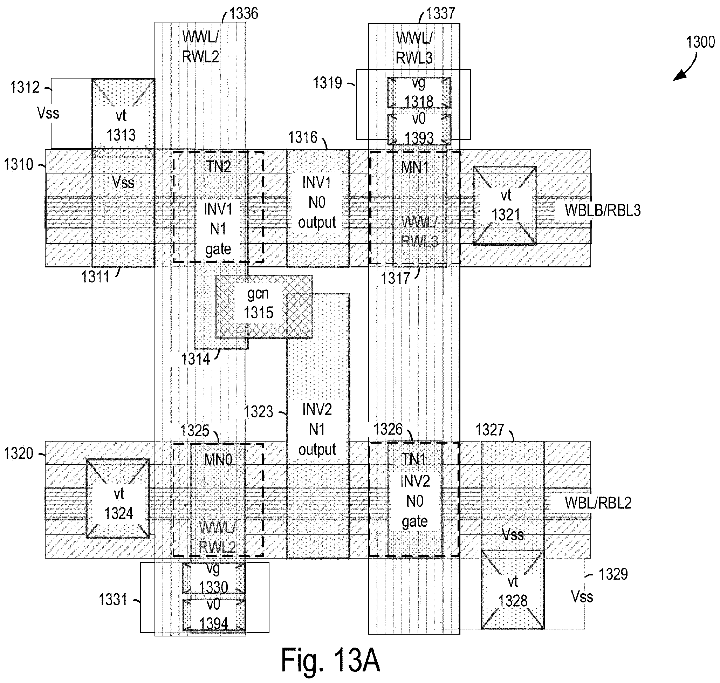

FIG. 13A depicts an example plan view of a front side 1300 of an 8T SRAM cell consistent with FIGs. 3 and 5E, in accordance with various embodiments. The front side includes a first n-type transistor region 1310 with transistors TN2 and MN1, and a second n-type transistor region 1320 with transistors MN0 and TN1. Conductive paths are formed between the transistors and top and bottom metal layers to provide the cell 540 of FIG. 5E.

In the n-type transistor region 1310, the conductive path 1311 is coupled upward by a via 1313 to an M0 portion 1312 for Vss.

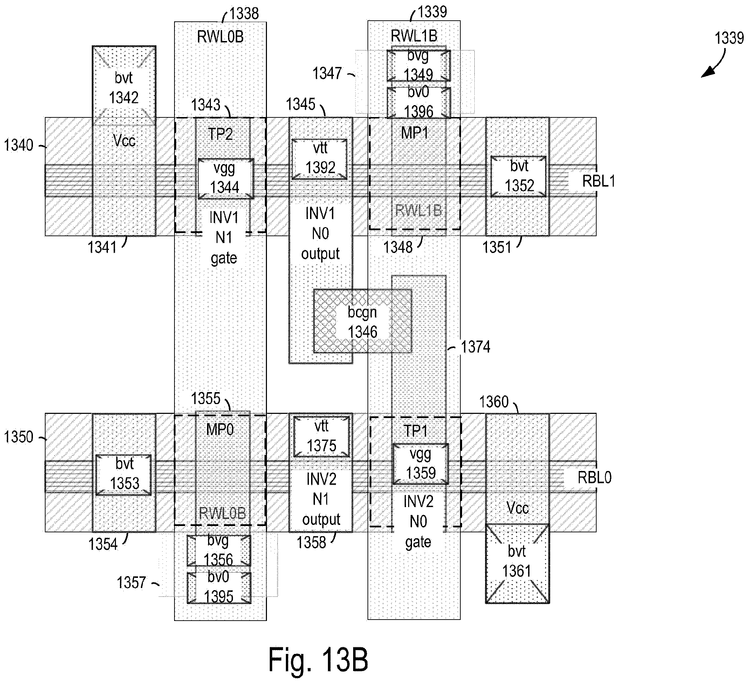

The conductive path 1314 (representing INV1 N1 gate) extends laterally from an area in which it forms a control gate of TN2 to a conductive path 1323 (representing INV2 N1 output) which extends from a source/drain terminal of MN0 and TN1. These two conductive paths can be coupled to one another by a gcn 1315. The conductive path 1314 is also coupled downward by a via 1344 to a conductive path 1343 which forms a control gate of TP2 (FIG. 13B).

The conductive path 1316 (representing INV1 NO output) overlays the source/drain terminals of TN2 and MN1 and is coupled downward by a via 1392 to a conductive path 1345 (FIG. 13B).

The conductive path 1317 forms the control gate of MN1 and is coupled upward by the via 1318 to an M0 portion 1319 and from there further upward by a via 1393 to an M1 portion for WWL/RWL3 1337. The two vias are shown as being laterally offset but could alternatively be directly on top of one another.

A source/drain terminal of MN1 is coupled upward by the via 1321 to an M0 portion for WBLB/RBL3.

In the n-type transistor region 1320, a source/drain terminal of MN0 extends upward by the via 1324 to an M0 portion for WBL/RBL2.

The conductive path 1325 forms the control gate of MN0 and is coupled upward by the via 1330 to an M0 portion 1331, and from there further upward by a via 1394 to an M1 portion for WWL/RWL2 1336.

The conductive path 1326 (representing INV2 NO gate) is coupled downward by the via 1359 to a conductive path 1374 (FIG. 13B).

The conductive path 1327 is coupled upward by a via 1328 to an M0 portion 1329 for Vss.

M0 portions 1312, 1319, 1331 and 1329 extend in the x direction and denote Vss, WWL/RWL3, WWL/RWL2 and Vss, respectively. M1 portions 1336 and 1337 extend in the y direction and represent WWL/RWL2 and WWL/RWL3, respectively.

A conductive path which includes the M1 portion 1336 extends down through the via 1394 to the M0 portion 1331, which in turn extends down through the via 1330 to the conductive path 1325.

A conductive path which includes the M1 portion 1337 extends down through the via 1393 to the M0 portion 1319, which in turn extends down through the via 1318 to the conductive path 1317.

FIG. 13B depicts an example plan view of a back side 1339 of the SRAM cell consistent with FIGs. 3 and 5E in accordance with various embodiments. The back side includes a first p-type transistor region 1340 with transistors TP2 and MP1, and a second p-type transistor region 1350 with transistors MP0 and TP1.

In the p-type transistor region 1340, a conductive path 1341 at a source/drain terminal of TP2 extends downward by a via 1342 to a BMO portion for Vcc.

A conductive path 1343 (representing INV1 N1 gate, the control gate of TP2) extends upward by a via 1344 to the conductive path 1314 of FIG. 13A.

A conductive path 1345 (representing INV1 NO output) extends from a source/drain terminal of TP2 and MP1 to a conductive path 1374 which extends from a control gate of TP1 (representing INV2 NO gate). These two conductive paths can be coupled to one another by a bgcn 1346. The conductive path 1345 also extends upwards by a via 1392 to the conductive path 1316 (FIG. 13A).

A conductive path 1348, representing the control gate of MP1, extends downwards by a via 1349 to the BMO portion 1347, and from there further downward by a via 1396 to a BM1 portion for RWL1B 1339.

A conductive path 1351 at a source/drain terminal of MP1 extends downward by a via 1352 to a BMO portion for RBL1.

In the p-type transistor region 1350, a conductive path 1354 at a source/drain terminal of MP0 extends downward by a via 1353 to a BMO portion for RBL0.

A conductive path 1355, representing the control gate of MP0, extends downwards by a via 1356 to a BMO portion 1357 and from there further down by a via 1395 to a BM1 portion for RWLOB 1338.

A conductive path 1358 (representing INV2 N1 output) extends upward by a via 1375 to the conductive path 1323 of FIG. 12A.

A conductive path 1374 (representing INV2 NO gate) extends upward by a via 1359 to the conductive path 1326 of FIG. 13A.

A conductive path 1360 at a source/drain terminal of T`N1 extends downward by a via 1361 to a BMO portion for Vcc.

BM1 portions 1338 and 1339 are also depicted which represent RWLOB and RWL1B, respectively. A conductive path extends from the BM1 portion 1338 upward by the via 1395 to the BMO portion 1357 and from there further upward by the via 1356 to the conductive portion 1355. A conductive path also extends from the BM1 portion 1339 upward by the via 1396 to the BMO portion 1347 and from there further upward by the via 1349 to the conductive portion 1348.

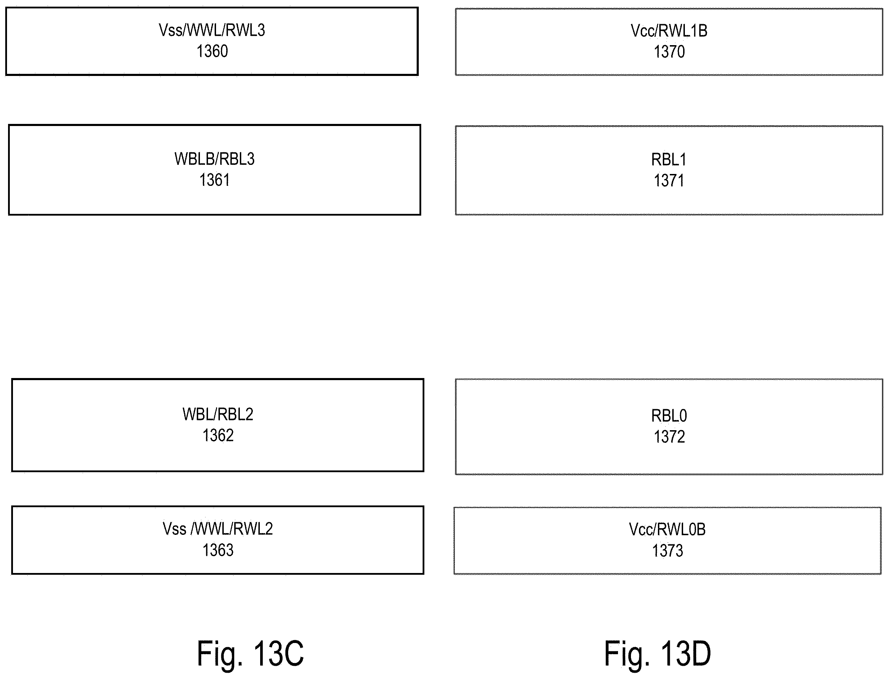

FIG. 13C depicts an example plan view of an M0 layer of the SRAM cell consistent with FIGs. 3 and 5E, in accordance with various embodiments. M0 includes a portion 1360 representing Vss/WWL/RWL3, a portion 1361 representing WBLB/RBL3, a portion 1362 representing WBL/RBL2, and a portion 1363 representing Vss/WWL/RWL2.

FIG. 13D depicts an example plan view of a BMO layer of the SRAM cell consistent with FIGs. 3 and 5E, in accordance with various embodiments. BMO includes a portion 1370 representing Vcc/RWL1B, a portion 1371 representing RBL1, a portion 1372 representing RBL0, and a portion 1373 representing Vcc/RWL0B.

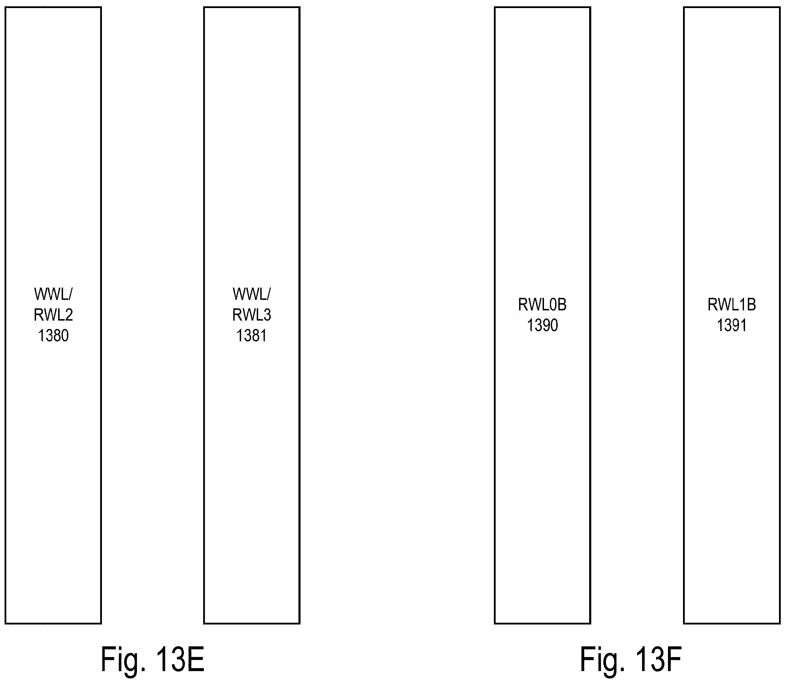

FIG. 13E depicts an example plan view of an M1 layer of the SRAM cell consistent with FIGs. 3 and 5E, in accordance with various embodiments. M1 includes a portion 1380 representing WWL/RWL2 and a portion 1381 representing WWL/RWL3.

FIG. 13F depicts an example plan view of a BM1 layer of the SRAM cell consistent with FIGs. 3 and 5E, in accordance with various embodiments. BM1 includes a portion 1390 representing RWLOB and a portion 1391 representing RWL1B.

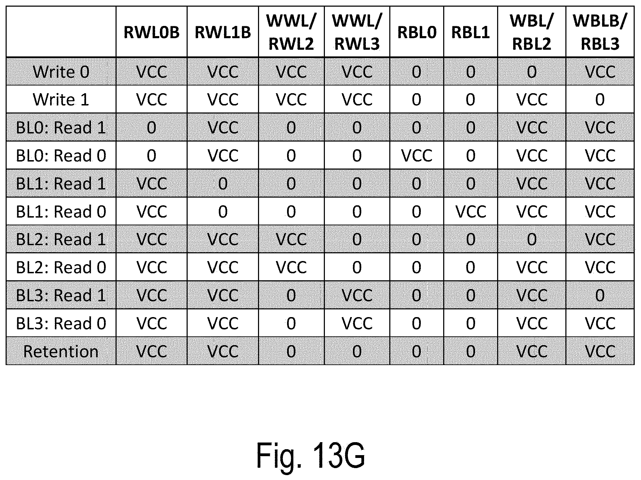

FIG. 13G depicts an example table of word line and bit line voltages for write, read and retention operations in the SRAM cell of FIG. 5E, in accordance with various embodiments. BL2 and BL3 read operation and write operation cannot happen simultaneously. One operation at a time is performed.

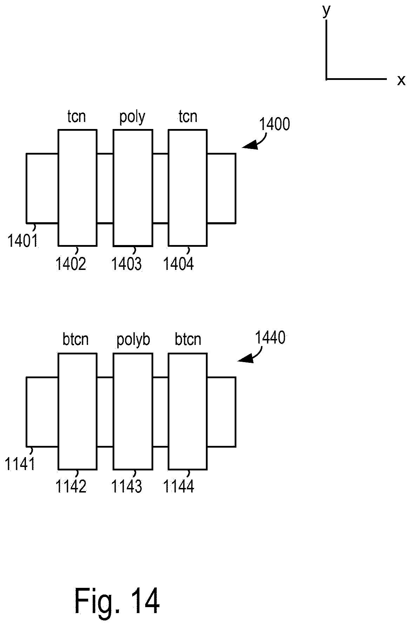

FIGs. 14 and 15 provide examples of layers used in the CFET process.

FIG. 14 depicts an example view of an n-type metal-oxide-semiconductor field-effect transistor (nMOSFET) 1400 and p-type MOSFET 1440, in accordance with various embodiments. The nMOS 1400 includes an active area 1401 and conductive paths ten 1402, poly 1403 and ten 1404, which extend over the active area in the x-y plane. The pMOS 1140 includes an active area 1141 and conductive paths btcn 1142, polyb 1143 and btcn 1144, which extend over the active area in the x-y plane. See also FIG. 15.

FIG. 15 depicts an example perspective view of different layers and vias in an SRAM cell which uses CFET technology, in accordance with various embodiments. Starting at the bottom, in ascending order, there are bottom metal layers BM2 1501, BM1 1502 and BMO 1503. A via bv1 couple BM2 and BM1, and a via bv0 1531 couple BM1 and BM0.

Vias bvt 1504 and bvg 1505 are used to couple BMO to btcn 1506 and polyb 1507, respectively, which are conductive paths which extend in the x-y plane.

Vias vtt 1515 and vgg 1516 are used to couple btcn and polyb, respectively, to ten 1517 and poly 1518, respectively.

Vias vt 1520 and vg 1521 are used to couple ten and poly, respectively, to M0 1522. M0 1522, M1 1524 and M2 1526 are example first, second and third top metal layers, respectively.

Conductive paths polyb 1508 and btcn 1509 are coupled by vias vgx 1527 and vtx 1529, respectively, to M0.

M0 is coupled to M1 by via v0 1523, and M1 is coupled to M2 by via v1 1525.

Use of a shorter via to connect to the nMOS or pMOS layer a metal layer is preferable to reduce capacitance and complexity. The closest metal layer may be below or above in different cases.

A lower layer (LL) and an upper layer (UL), consistent with FIGs. 2 and 3, are also depicted. For example, one layer can be an n-type transistor layer and the other layer can be a p-type transistor layer.

Note that it is also possible to use one or more intermediate metal (IM) layers between M0 and BM0 to provide interconnects. In an example implementation, the one or more intermediate metal layers comprise a first intermediate metal layer having tracks extending in a first direction (e.g., x-direction) and a second intermediate metal layers comprising tracks extending in a second direction (e.g., y-direction), perpendicular to the first direction. The IM layers can provide routing between the nMOS and pMOS transistors in their different respective levels as well to one or more top metal layers and to one or more bottom metal layers. The IM layers help reduce the area of the cell.

FIG. 16 illustrates an example of components that may be present in a computing system 1650 for implementing the techniques (e.g., operations, processes, methods, and methodologies) described herein.

The CFET memory cells described herein can be used in any of the components of the computing system 1650. One example implementation involves the memory circuitry 1654.

The voltage regulator 1600 may provide a voltage Vout to one or more of the components of the computing system 1650.

The memory circuitry 1654 may store instructions and the processor circuitry 1252 may execute the instructions to perform the functions described herein.

The computing system 1650 may include any combinations of the hardware or logical components referenced herein. The components may be implemented as ICs, portions thereof, discrete electronic devices, or other modules, instruction sets, programmable logic or algorithms, hardware, hardware accelerators, software, firmware, or a combination thereof adapted in the computing system 1650, or as components otherwise incorporated within a chassis of a larger system.

The voltage regulator can provide a voltage Vout to one or more of the components of the computing system 1650. The memory circuitry 1654 may store instructions and the processor circuitry 1652 may execute the instructions to perform the functions described herein.

The system 1650 includes processor circuitry in the form of one or more processors 1652. The processor circuitry 1652 includes circuitry such as, but not limited to one or more processor cores and one or more of cache memory, low drop-out voltage regulators (LDOs), interrupt controllers, serial interfaces such as SPI, I2C or universal programmable serial interface circuit, real time clock (RTC), timer-counters including interval and watchdog timers, general purpose I/O, memory card controllers such as secure digital/multi-media card (SD/MMC) or similar, interfaces, mobile industry processor interface (MIPI) interfaces and Joint Test Access Group (JTAG) test access ports. In some implementations, the processor circuitry 1652 may include one or more hardware accelerators (e.g., same or similar to acceleration circuitry 1664), which may be microprocessors, programmable processing devices (e.g., FPGA, ASIC, etc.), or the like. The one or more accelerators may include, for example, computer vision and/or deep learning accelerators. In some implementations, the processor circuitry 1652 may include on-chip memory circuitry, which may include any suitable volatile and/or non-volatile memory, such as DRAM, SRAM, EPROM, EEPROM, Flash memory, solid-state memory, and/or any other type of memory device technology, such as those discussed herein

The processor circuitry 1652 may include, for example, one or more processor cores (CPUs), application processors, GPUs, RISC processors, Acorn RISC Machine (ARM) processors, CISC processors, one or more DSPs, one or more FPGAs, one or more PLDs, one or more ASICs, one or more baseband processors, one or more radio-frequency integrated circuits (RFIC), one or more microprocessors or controllers, a multi-core processor, a multithreaded processor, an ultra-low-voltage processor, an embedded processor, or any other known processing elements, or any suitable combination thereof. The processors (or cores) 1652 may be coupled with or may include memory/storage and may be configured to execute instructions stored in the memory/storage to enable various applications or operating systems to run on the platform 1650. The processors (or cores) 1652 is configured to operate application software to provide a specific service to a user of the platform 1650. In some embodiments, the processor(s) 1652 may be a special-purpose processor(s)/controller(s) configured (or configurable) to operate according to the various embodiments herein.

As examples, the processor(s) 1652 may include an Intel^{®} Architecture Core^{™} based processor such as an i3, an i5, an i7, an i9 based processor; an Intel^{®} microcontroller-based processor such as a Quark^{™}, an Atom^{™}, or other MCU-based processor; Pentium^{®} processor(s), Xeon^{®} processor(s), or another such processor available from Intel^{®} Corporation, Santa Clara, California. However, any number other processors may be used, such as one or more of Advanced Micro Devices (AMD) Zen^{®} Architecture such as Ryzen^{®} or EPYC^{®} processor(s), Accelerated Processing Units (APUs), MxGPUs, Epyc^{®} processor(s), or the like; A5-A12 and/or S1-S4 processor(s) from Apple^{®} Inc., Snapdragon^{™} or Centriq^{™} processor(s) from Qualcomm^{®} Technologies, Inc., Texas Instruments, Inc.^{®} Open Multimedia Applications Platform (OMAP)^{™} processor(s); a MIPS-based design from MIPS Technologies, Inc. such as MIPS Warrior M-class, Warrior I-class, and Warrior P-class processors; an ARM-based design licensed from ARM Holdings, Ltd., such as the ARM Cortex-A, Cortex-R, and Cortex-M family of processors; the ThunderX2^{®} provided by Cavium^{™}, Inc.; or the like. In some implementations, the processor(s) 1652 may be a part of a system on a chip (SoC), System-in-Package (SiP), a multi-chip package (MCP), and/or the like, in which the processor(s) 1652 and other components are formed into a single integrated circuit, or a single package, such as the Edison^{™} or Galileo^{™} SoC boards from Intel^{®} Corporation. Other examples of the processor(s) 1652 are mentioned elsewhere in the present disclosure.

The system 1650 may include or be coupled to acceleration circuitry 1664, which may be embodied by one or more AI/ML accelerators, a neural compute stick, neuromorphic hardware, an FPGA, an arrangement of GPUs, one or more SoCs (including programmable SoCs), one or more CPUs, one or more digital signal processors, dedicated ASICs (including programmable ASICs), PLDs such as complex (CPLDs) or high complexity PLDs (HCPLDs), and/or other forms of specialized processors or circuitry designed to accomplish one or more specialized tasks. These tasks may include AI/ML processing (e.g., including training, inferencing, and classification operations), visual data processing, network data processing, object detection, rule analysis, or the like. In FPGA-based implementations, the acceleration circuitry 1664 may comprise logic blocks or logic fabric and other interconnected resources that may be programmed (configured) to perform various functions, such as the procedures, methods, functions, etc. of the various embodiments discussed herein. In such implementations, the acceleration circuitry 1664 may also include memory cells (e.g., EPROM, EEPROM, flash memory, static memory (e.g., SRAM, anti-fuses, etc.) used to store logic blocks, logic fabric, data, etc. in LUTs and the like.

In some implementations, the processor circuitry 1652 and/or acceleration circuitry 1664 may include hardware elements specifically tailored for machine learning and/or artificial intelligence (AI) functionality. In these implementations, the processor circuitry 1652 and/or acceleration circuitry 1664 may be, or may include, an AI engine chip that can run many different kinds of AI instruction sets once loaded with the appropriate weightings and training code. Additionally or alternatively, the processor circuitry 1652 and/or acceleration circuitry 1664 may be, or may include, AI accelerator(s), which may be one or more of the aforementioned hardware accelerators designed for hardware acceleration of AI applications. As examples, these processor(s) or accelerators may be a cluster of artificial intelligence (AI) GPUs, tensor processing units (TPUs) developed by Google^{®} Inc., Real AI Processors (RAPs^{™}) provided by AlphaICs^{®}, Nervana^{™} Neural Network Processors (NNPs) provided by Intel^{®} Corp., Intel^{®} Movidius^{™} Myriad^{™} X Vision Processing Unit (VPU), NVIDIA^{®} PX^{™} based GPUs, the NM500 chip provided by General Vision^{®}, Hardware 3 provided by Tesla^{®}, Inc., an Epiphany^{™} based processor provided by Adapteva^{®}, or the like. In some embodiments, the processor circuitry 1652 and/or acceleration circuitry 1664 and/or hardware accelerator circuitry may be implemented as AI accelerating co-processor(s), such as the Hexagon 685 DSP provided by Qualcomm^{®}, the PowerVR 2NX Neural Net Accelerator (NNA) provided by Imagination Technologies Limited^{®}, the Neural Engine core within the Applet A11 or A12 Bionic SoC, the Neural Processing Unit (NPU) within the HiSilicon Kirin provided by Huawei^{®}, and/or the like. In some hardware-based implementations, individual subsystems of system 1650 may be operated by the respective AI accelerating co-processor(s), AI GPUs, TPUs, or hardware accelerators (e.g., FPGAs, ASICs, DSPs, SoCs, etc.), etc., that are configured with appropriate logic blocks, bit stream(s), etc. to perform their respective functions.

The system 1650 also includes system memory 1654. Any number of memory devices may be used to provide for a given amount of system memory. As examples, the memory 1654 may be, or include, volatile memory such as random access memory (RAM), static RAM (SRAM), dynamic RAM (DRAM), synchronous DRAM (SDRAM), RAMBUS^{®} Dynamic Random Access Memory (RDRAM^{®}), and/or any other desired type of volatile memory device. Additionally or alternatively, the memory 1654 may be, or include, non-volatile memory such as read-only memory (ROM), erasable programmable ROM (EPROM), electrically erasable programmable (EEPROM), flash memory, non-volatile RAM, ferroelectric RAM, phase-change memory (PCM), flash memory, and/or any other desired type of non-volatile memory device. Access to the memory 1654 is controlled by a memory controller. The individual memory devices may be of any number of different package types such as single die package (SDP), dual die package (DDP) or quad die package (Q17P). Any number of other memory implementations may be used, such as dual inline memory modules (DIMMs) of different varieties including but not limited to microDIMMs or MiniDIMMs.

Storage circuitry 1658 provides persistent storage of information such as data, applications, operating systems and so forth. In an example, the storage 1658 may be implemented via a solid-state disk drive (SSDD) and/or high-speed electrically erasable memory (commonly referred to as "flash memory"). Other devices that may be used for the storage 1658 include flash memory cards, such as SD cards, microSD cards, XD picture cards, and the like, and USB flash drives. In an example, the memory device may be or may include memory devices that use chalcogenide glass, multi-threshold level NAND flash memory, NOR flash memory, single or multi-level Phase Change Memory (PCM), a resistive memory, nanowire memory, ferroelectric transistor random access memory (FeTRAM), anti-ferroelectric memory, magnetoresistive random access memory (MRAM) memory that incorporates memristor technology, phase change RAM (PRAM), resistive memory including the metal oxide base, the oxygen vacancy base and the conductive bridge Random Access Memory (CB-RAM), or spin transfer torque (STT)-MRAM, a spintronic magnetic junction memory based device, a magnetic tunneling junction (MTJ) based device, a Domain Wall (DW) and Spin Orbit Transfer (SOT) based device, a thyristor based memory device, a hard disk drive (HDD), micro HDD, of a combination thereof, and/or any other memory. The memory circuitry 1654 and/or storage circuitry 1658 may also incorporate three-dimensional (3D) cross-point (XPOINT) memories from Intel^{®} and Micron^{®}.

The memory circuitry 1654 and/or storage circuitry 1658 is/are configured to store computational logic 1683 in the form of software, firmware, microcode, or hardware-level instructions to implement the techniques described herein. The computational logic 1683 may be employed to store working copies and/or permanent copies of programming instructions, or data to create the programming instructions, for the operation of various components of system 1650 (e.g., drivers, libraries, application programming interfaces (APIs), etc.), an operating system of system 1650, one or more applications, and/or for carrying out the embodiments discussed herein. The computational logic 1683 may be stored or loaded into memory circuitry 1654 as instructions 1682, or data to create the instructions 1682, which are then accessed for execution by the processor circuitry 1652 to carry out the functions described herein. The processor circuitry 1652 and/or the acceleration circuitry 1664 accesses the memory circuitry 1654 and/or the storage circuitry 1658 over the interconnect (IX) 1656. The instructions 1682 direct the processor circuitry 1652 to perform a specific sequence or flow of actions, for example, as described with respect to flowchart(s) and block diagram(s) of operations and functionality depicted previously. The various elements may be implemented by assembler instructions supported by processor circuitry 1652 or high-level languages that may be compiled into instructions 1688, or data to create the instructions 1688, to be executed by the processor circuitry 1652. The permanent copy of the programming instructions may be placed into persistent storage devices of storage circuitry 1658 in the factory or in the field through, for example, a distribution medium (not shown), through a communication interface (e.g., from a distribution server (not shown)), over-the-air (OTA), or any combination thereof.

The IX 1656 couples the processor 1652 to communication circuitry 1666 for communications with other devices, such as a remote server (not shown) and the like. The communication circuitry 1666 is a hardware element, or collection of hardware elements, used to communicate over one or more networks 1663 and/or with other devices. In one example, communication circuitry 1666 is, or includes, transceiver circuitry configured to enable wireless communications using any number of frequencies and protocols such as, for example, the Institute of Electrical and Electronics Engineers (IEEE) 802.11 (and/or variants thereof), IEEE 802.23.4, Bluetooth^{®} and/or Bluetooth^{®} low energy (BLE), ZigBee^{®}, LoRaWAN^{™} (Long Range Wide Area Network), a cellular protocol such as 3GPP LTE and/or Fifth Generation (5G)/New Radio (NR), and/or the like. Additionally or alternatively, communication circuitry 1666 is, or includes, one or more network interface controllers (NICs) to enable wired communication using, for example, an Ethernet connection, Controller Area Network (CAN), Local Interconnect Network (LIN), DeviceNet, ControlNet, Data Highway+, or PROFINET, among many others.

The IX 1656 also couples the processor 1652 to interface circuitry 1670 that is used to connect system 1650 with one or more external devices 1672. The external devices 1672 may include, for example, sensors, actuators, positioning circuitry (e.g., global navigation satellite system (GNSS)/Global Positioning System (GPS) circuitry), client devices, servers, network appliances (e.g., switches, hubs, routers, etc.), integrated photonics devices (e.g., optical neural network (ONN) integrated circuit (IC) and/or the like), and/or other like devices.

In some optional examples, various input/output (I/O) devices may be present within or connected to, the system 1650, which are referred to as input circuitry 1686 and output circuitry 1684. The input circuitry 1686 and output circuitry 1684 include one or more user interfaces designed to enable user interaction with the platform 1650 and/or peripheral component interfaces designed to enable peripheral component interaction with the platform 1650. Input circuitry 1686 may include any physical or virtual means for accepting an input including, inter alia, one or more physical or virtual buttons (e.g., a reset button), a physical keyboard, keypad, mouse, touchpad, touchscreen, microphones, scanner, headset, and/or the like. The output circuitry 1684 may be included to show information or otherwise convey information, such as sensor readings, actuator position(s), or other like information. Data and/or graphics may be displayed on one or more user interface components of the output circuitry 1684. Output circuitry 1684 may include any number and/or combinations of audio or visual display, including, inter alia, one or more simple visual outputs/indicators (e.g., binary status indicators (e.g., light emitting diodes (LEDs)) and multi-character visual outputs, or more complex outputs such as display devices or touchscreens (e.g., Liquid Crystal Displays (LCD), LED displays, quantum dot displays, projectors, etc.), with the output of characters, graphics, multimedia objects, and the like being generated or produced from the operation of the platform 1650. The output circuitry 1684 may also include speakers and/or other audio emitting devices, printer(s), and/or the like. Additionally or alternatively, sensor(s) may be used as the input circuitry 1684 (e.g., an image capture device, motion capture device, or the like) and one or more actuators may be used as the output device circuitry 1684 (e.g., an actuator to provide haptic feedback or the like). Peripheral component interfaces may include, but are not limited to, a non-volatile memory port, a USB port, an audio jack, a power supply interface, etc. In some embodiments, a display or console hardware, in the context of the present system, may be used to provide output and receive input of an edge computing system; to manage components or services of an edge computing system; identify a state of an edge computing component or service; or to conduct any other number of management or administration functions or service use cases.

The components of the system 1650 may communicate over the IX 1656. The IX 1656 may include any number of technologies, including ISA, extended ISA, I2C, SPI, point-to-point interfaces, power management bus (PMBus), PCI, PCIe, PCIx, Intel^{®} UPI, Intel^{®} Accelerator Link, Intel^{®} CXL, CAPI, OpenCAPI, Intel^{®} QPI, UPI, Intel^{®} OPA IX, RapidIO^{™} system IXs, CCIX, Gen-Z Consortium IXs, a HyperTransport interconnect, NVLink provided by NVIDIA^{®}, a Time-Trigger Protocol (TTP) system, a FlexRay system, PROFIBUS, and/or any number of other IX technologies. The IX 1656 may be a proprietary bus, for example, used in a SoC based system.

The number, capability, and/or capacity of the elements of system 1650 may vary, depending on whether computing system 1650 is used as a stationary computing device (e.g., a server computer in a data center, a workstation, a desktop computer, etc.) or a mobile computing device (e.g., a smartphone, tablet computing device, laptop computer, game console, IoT device, etc.). In various implementations, the computing device system 1650 may comprise one or more components of a data center, a desktop computer, a workstation, a laptop, a smartphone, a tablet, a digital camera, a smart appliance, a smart home hub, a network appliance, and/or any other device/system that processes data.

FIG. 17 depicts a flowchart of an example process for operating an SRAM cell, in accordance with various embodiments. Operation 1700 includes performing one or more read operations of an SRAM cell through p-type bit line access transistors. Operation 1701 includes performing one or more write operations of an SRAM cell through n-type bit line access transistors.

The techniques described herein can be performed partially or wholly by software or other instructions provided in a machine-readable storage medium (e.g., memory). The software is stored as processor-executable instructions (e.g., instructions to implement any other processes discussed herein). Instructions associated with the flowchart (and/or various embodiments) and executed to implement embodiments of the disclosed subject matter may be implemented as part of an operating system or a specific application, component, program, object, module, routine, or other sequence of instructions or organization of sequences of instructions.

The storage medium can be a tangible, non-transitory machine readable medium such as read only memory (ROM), random access memory (RAM), flash memory devices, floppy and other removable disks, magnetic storage media, optical storage media (e.g., Compact Disk Read-Only Memory (CD ROMS), Digital Versatile Disks (DVDs)), among others.

The storage medium may be included, e.g., in a communication device, a computing device, a network device, a personal digital assistant, a manufacturing tool, a mobile communication device, a cellular phone, a notebook computer, a tablet, a game console, a set top box, an embedded system, a TV (television), or a personal desktop computer.

Some non-limiting examples of various embodiments are presented below.

Example 1 includes an apparatus, comprising: first and second inverters which are cross-coupled and which comprise transistors in first and second p-type transistor regions and first and second n-type transistor regions, wherein the first and second p-type transistor regions are on a first level and the first and second n-type transistor regions are on a second level; and bit line access transistors in the first and second p-type transistor regions and first and second n-type transistor regions, wherein: the first inverter comprises a p-type transistor (TP1) in the first p-type transistor region, coupled in series with an n-type transistor (TN1) in the second n-type transistor region; and the second inverter comprises a p-type transistor (TP2) in the second p-type transistor region, coupled in series with an n-type transistor (TN2) in the first n-type transistor region.

Example 2 include the apparatus of Example 1, further comprising: a first node (N0) coupled to an output node of the first inverter and an input node of the second inverter; and a second node (N1) coupled to an input node of the first inverter and an output node of the second inverter; wherein: the bit line access transistors comprise first and second p-type bit line access transistors (MP1, MP0) coupled to the first and second nodes, respectively, and first and second n-type bit line access transistors (MN1, MN0) coupled to the first and second nodes, respectively.

Example 3 include the apparatus of Example 2, wherein: the first p-type bit line access transistor (MP1) is in the first p-type transistor region; the second p-type bit line access transistor (MP0) is in the second p-type transistor region; the first n-type bit line access transistor (MN1) is in the first n-type transistor region; and the second n-type bit line access transistor (MN0) is in the second n-type transistor region.

Example 4 include the apparatus of Example 2, further comprising: a control line coupled to control gates of the first and second n-type bit line access transistors (MN1, MN0); and separate control lines coupled to control gates of the first and second p-type bit line access transistors (MP1, MP0).

Example 5 include the apparatus of Example 2, further comprising: a control line coupled to control gates of the first and second n-type bit line access transistors (MN1, MN0); and a control line coupled to control gates of the first and second p-type bit line access transistors (MP1, MP0).

Example 6 include the apparatus of Example 2, further comprising: separate control lines coupled to control gates of the first and second n-type bit line access transistors (MN1, MN0); and separate control lines coupled to control gates of the first and second p-type bit line access transistors (MP1, MP0).

Example 7 include the apparatus of any one of Examples 2-7, wherein the apparatus is static random-access memory (SRAM) cell configured to support read operations through the first and second p-type bit line access transistors and a write operation through the first and second n-type bit line access transistors.

Example 8 include the apparatus of any one of Examples 1-7, wherein the apparatus is static random-access memory (SRAM) cell which is reconfigurable for various port configurations including 1R1W (1-read 1-write), 2R1W (2-read 1-write), 3R1W (3-read 1-write), and 4R1W (4-read 1-write).

Example 9 include the apparatus of any one of Examples 1-8, further comprising a via to couple a control gate of the p-type transistor (TP1) of the first inverter to a control gate of the n-type transistor (TN1) of the first inverter, and a via to couple a control gate of the p-type transistor (TP2) of the second inverter to a control gate of the n-type transistor (TN2) of the second inverter.

Example 10 include the apparatus of any one of Examples 1-9, wherein the first level is below the second level.

Example 11 include the apparatus of any one of Examples 1-10, further comprising a complementary field-effect transistor (CFET) device which includes the first and second inverters and the bit line access transistors, wherein the CFET device is provided in at least one of an integrated circuit, a System on Chip, a System in Package or a computing device.

Example 12 includes a memory cell, comprising: one or more p-type transistor regions at a first level of the memory cell; one or more n-type transistor regions at a second level of the memory cell, above or below the first level; and first and second inverters distributed over the one or more p-type transistor regions and the one or more n-type transistor regions; wherein: the first inverter comprises a first via which extends between the first and second level to couple a control gate of a p-type transistor (TP1) of the first inverter to a control gate of an n-type transistor (TN1) of the first inverter; and the second inverter comprises a second via which extends between the first and second level to couple a control gate of a p-type transistor (TP2) of the second inverter to a control gate of an n-type transistor (TN2) of the second inverter.

Example 13 include the memory cell of Example 12, wherein the one or more p-type transistor regions comprise: a first p-type bit line access transistor (MP0) coupled to the control gates of the p-type and n-type transistors of the first inverter; and a second p-type bit line access transistor (MP1) coupled to the control gates of the p-type and n-type transistors of the second inverter.

Example 14 include the memory cell of Example 12, wherein the one or more n-type transistor regions comprise: a first n-type bit line access transistor (MN0) coupled to the control gates of the p-type and n-type transistors of the first inverter; and a second n-type bit line access transistor (MN1) coupled to the control gates of the p-type and n-type transistors of the second inverter.

Example 15 include the memory cell of Example 12, wherein: the one or more p-type transistor regions comprise first and second bit line access transistors which are configured to support read operations; and the one or more n-type transistor regions comprise first and second bit line access transistors which are configured to support a write operation.

Example 16 includes a system, comprising: a memory to store instructions; and a processor to execute the instructions to perform read and write operations in a static random-access memory (SRAM) cell, wherein: the SRAM cell comprises first and second inverters distributed over one or more p-type transistor regions and one or more n-type transistor regions; the one or more p-type transistor regions are at a first level of SRAM cell; the one or more n-type transistor regions are at a second level of the memory cell, above or below the first level; the read operations are to be performed through p-type bit line access transistors; and the write operations are to be performed through first and second n-type bit line access transistors.

Example 17 include the system of Example 16, wherein the SRAM cell is an eight-transistor cell and is reconfigurable for various port configurations including 1R1W (1-read 1-write), 2R1W (2-read 1-write), 3R1W (3-read 1-write), and 4R1W (4-read 1-write).

Example 18 include the system of Example 16 or 17, wherein in the read and write operations, the processor is to execute the instructions to provide a common control gate voltage to the n-type bit line access transistors and separate control gate voltages to the p-type bit line access transistors.

Example 19 include the system of Example 16 or 17, wherein in the read and write operations, the processor is to execute the instructions to provide a common control gate voltage to the n-type bit line access transistors and a common control gate voltage to the p-type bit line access transistors.

Example 20 include the system of Example 16 or 17, wherein in the read and write operations, the processor is to execute the instructions to provide separate control gate voltage to the n-type bit line access transistors and separate control gate voltage to the p-type bit line access transistors.

Example 21 includes a method for operating a static random-access memory (SRAM) cell, comprising: performing one or more read operations through p-type bit line access transistors; and performing one or more write operations through n-type bit line access transistors, wherein: the SRAM cell comprises first and second inverters distributed over one or more p-type transistor regions and one or more n-type transistor regions; the one or more p-type transistor regions are at a first level of SRAM cell; and the one or more n-type transistor regions are at a second level of the memory cell, above or below the first level.

Example 22 include the method of Example 21, wherein in the read and write operations, the processor is to execute the instructions to provide a common control gate voltage to the n-type bit line access transistors and separate control gate voltages to the p-type bit line access transistors.

Example 23 include the method of Example 21, wherein in the read and write operations, the processor is to execute the instructions to provide a common control gate voltage to the n-type bit line access transistors and a common control gate voltage to the p-type bit line access transistors.

Example 24 include the method of Example 21, wherein in the read and write operations, the processor is to execute the instructions to provide separate control gate voltage to the n-type bit line access transistors and separate control gate voltage to the p-type bit line access transistors.

Example 25 includes an apparatus, comprising means to perform the method of any one of Examples 21-23.

Example 25 includes a machine-readable storage including machine-readable instructions which, when executed, cause a computer to implement the method of any one of Examples 21-23.

Example 25 includes a computer program comprising instructions which, when executed by a computer, cause the computer to carry out the method of any one of Examples 21-23.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order than the described embodiment. Various additional operations may be performed and/or described operations may be omitted in additional embodiments.

The terms "substantially," "close," "approximately," "near," and "about," generally refer to being within +/- 10% of a target value. Unless otherwise specified the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

For the purposes of the present disclosure, the phrases "A and/or B" and "A or B" mean (A), (B), or (A and B). For the purposes of the present disclosure, the phrase "A, B, and/or C" means (A), (B), (C), (A and B), (A and C), (B and C), or (A, B, and C).

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

As used herein, the term "circuitry" may refer to, be part of, or include an Application Specific Integrated Circuit (ASIC), an electronic circuit, a processor (shared, dedicated, or group), a combinational logic circuit, and/or other suitable hardware components that provide the described functionality. As used herein, "computer-implemented method" may refer to any method executed by one or more processors, a computer system having one or more processors, a mobile device such as a smartphone (which may include one or more processors), a tablet, a laptop computer, a set-top box, a gaming console, and so forth.

The terms "coupled," "communicatively coupled," along with derivatives thereof are used herein. The term "coupled" may mean two or more elements are in direct physical or electrical contact with one another, may mean that two or more elements indirectly contact each other but still cooperate or interact with each other, and/or may mean that one or more other elements are coupled or connected between the elements that are said to be coupled with each other. The term "directly coupled" may mean that two or more elements are in direct contact with one another. The term "communicatively coupled" may mean that two or more elements may be in contact with one another by a means of communication including through a wire or other interconnect connection, through a wireless communication channel or link, and/or the like.

Reference in the specification to "an embodiment," "one embodiment," "some embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. If the specification states a component, feature, structure, or characteristic "may," "might," or "could" be included, that particular component, feature, structure, or characteristic is not required to be included. If the specification or claim refers to "a" or "an" element, that does not mean there is only one of the elements. If the specification or claims refer to "an additional" element, that does not preclude there being more than one of the additional elements.

Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

While the disclosure has been described in conjunction with specific embodiments thereof, many alternatives, modifications and variations of such embodiments will be apparent to those of ordinary skill in the art in light of the foregoing description. The embodiments of the disclosure are intended to embrace all such alternatives, modifications, and variations as to fall within the broad scope of the appended claims.

In addition, well-known power/ground connections to integrated circuit (IC) chips and other components may or may not be shown within the presented figures, for simplicity of illustration and discussion, and so as not to obscure the disclosure. Further, arrangements may be shown in block diagram form in order to avoid obscuring the disclosure, and also in view of the fact that specifics with respect to implementation of such block diagram arrangements are highly dependent upon the platform within which the present disclosure is to be implemented (i.e., such specifics should be well within purview of one skilled in the art). Where specific details (e.g., circuits) are set forth in order to describe example embodiments of the disclosure, it should be apparent to one skilled in the art that the disclosure can be practiced without, or with variation of, these specific details. The description is thus to be regarded as illustrative instead of limiting.

An abstract is provided that will allow the reader to ascertain the nature and gist of the technical disclosure. The abstract is submitted with the understanding that it will not be used to limit the scope or meaning of the claims. The following claims are hereby incorporated into the detailed description, with each claim standing on its own as a separate embodiment.

## Claims

1. An apparatus, comprising:
first and second inverters which are cross-coupled and which comprise transistors in first and second p-type transistor regions and first and second n-type transistor regions, wherein the first and second p-type transistor regions are on a first level and the first and second n-type transistor regions are on a second level; and
bit line access transistors in the first and second p-type transistor regions and first and second n-type transistor regions, wherein:
the first inverter comprises a p-type transistor in the first p-type transistor region, coupled in series with an n-type transistor in the second n-type transistor region; and
the second inverter comprises a p-type transistor in the second p-type transistor region, coupled in series with an n-type transistor in the first n-type transistor region.

2. The apparatus of claim 1, further comprising:
a first node coupled to an output node of the first inverter and an input node of the second inverter; and
a second node coupled to an input node of the first inverter and an output node of the second inverter; wherein:
the bit line access transistors comprise first and second p-type bit line access transistors coupled to the first and second nodes, respectively, and first and second n-type bit line access transistors coupled to the first and second nodes, respectively.

3. The apparatus of claim 2, wherein:
the first p-type bit line access transistor is in the first p-type transistor region;
the second p-type bit line access transistor is in the second p-type transistor region;
the first n-type bit line access transistor is in the first n-type transistor region; and
the second n-type bit line access transistor is in the second n-type transistor region.

4. The apparatus of claim 2, further comprising:
a control line coupled to control gates of the first and second n-type bit line access transistors; and
separate control lines coupled to control gates of the first and second p-type bit line access transistors.

5. The apparatus of claim 2, further comprising:
a control line coupled to control gates of the first and second n-type bit line access transistors; and
a control line coupled to control gates of the first and second p-type bit line access transistors.

6. The apparatus of claim 2, further comprising:
separate control lines coupled to control gates of the first and second n-type bit line access transistors; and
separate control lines coupled to control gates of the first and second p-type bit line access transistors.

7. The apparatus of any one of claims 2-6, wherein the apparatus is static random-access memory (SRAM) cell configured to support read operations through the first and second p-type bit line access transistors and a write operation through the first and second n-type bit line access transistors.

8. The apparatus of any one of claims 1-7, wherein the apparatus is static random-access memory (SRAM) cell which is reconfigurable for various port configurations including 1R1W (1-read 1-write), 2R1W (2-read 1-write), 3R1W (3-read 1-write), and 4R1W (4-read 1-write).

9. The apparatus of any one of claims 1-8, further comprising a via to couple a control gate of the p-type transistor of the first inverter to a control gate of the n-type transistor of the first inverter, and a via to couple a control gate of the p-type transistor of the second inverter to a control gate of the n-type transistor of the second inverter.

10. The apparatus of any one of claims 1-9, wherein the first level is below the second level.

11. The apparatus of any one of claims 1-10, further comprising a complementary field-effect transistor (CFET) device which includes the first and second inverters and the bit line access transistors, wherein the CFET device is provided in at least one of an integrated circuit, a System on Chip, a System in Package or a computing device.

12. A method for operating a static random-access memory (SRAM) cell, comprising:
performing one or more read operations through p-type bit line access transistors; and
performing one or more write operations through first and second n-type bit line access transistors, wherein:
the SRAM cell comprises first and second inverters distributed over one or more p-type transistor regions and one or more n-type transistor regions;
the one or more p-type transistor regions are at a first level of SRAM cell; and
the one or more n-type transistor regions are at a second level of the memory cell, above or below the first level.

13. The method of claim 12, wherein in the read and write operations, the processor is to execute the instructions to provide a common control gate voltage to the n-type bit line access transistors and separate control gate voltages to the p-type bit line access transistors.

14. The method of claim 12, wherein in the read and write operations, the processor is to execute the instructions to provide a common control gate voltage to the n-type bit line access transistors and a common control gate voltage to the p-type bit line access transistors.

15. The method of claim 12, wherein in the read and write operations, the processor is to execute the instructions to provide separate control gate voltages to the n-type bit line access transistors and separate control gate voltages to the p-type bit line access transistors.
